# EUROPEAN PATENT APPLICATION

(11) **EP 4 712 730 A1**
(43) Date of publication of application: **18.03.2026**
(21) Application number: 25166648.3
(22) Date of filing: 27.03.2025
(51) Int. Cl.: H10D 84/01, H10D 30/01, H10D 30/00, H10D 30/67, H10D 64/23, H10D 88/00

(54) **SEMICONDUCTOR DEVICE**

(30) Priority: 13.09.2024 KR 20240125727
(71) Applicant: Samsung Electronics Co., Ltd., Suwon-si, Gyeonggi-do 16677 (KR)
(72) Inventor: HAN, Sangwoo, Suwon-si (KR); HWANG, Kyuman, Suwon-si (KR); PARK, Jae Hyun, Suwon-si (KR); PARK, Juhun, Suwon-si (KR); YUN, Jinchan, Suwon-si (KR); JEONG, Jae Won, Suwon-si (KR)
(74) Representative: Marks & Clerk LLP

(57) **Abstract**

A semiconductor device includes an active pattern spaced apart in a first direction, and extending in a second direction different from the first direction; a lower channel pattern and a lower source/drain pattern located on the active pattern and alternately arranged in the second direction; an upper channel pattern on the lower channel pattern, and an upper source/drain pattern on the lower source/drain pattern; a gate pattern extending in the first direction and located on the lower channel pattern and the upper channel pattern; a separation pattern located between one of the lower source/drain pattern and the upper source/drain pattern and another of the lower source/drain pattern and the upper source/drain pattern in the second direction; and a gate cutting pattern extending in the second direction across the gate pattern to separate the gate pattern.

## Description

### BACKGROUND

Development in the electronics industry demands certain characteristics of semiconductor devices, such as high reliability, high speed, and/or multifunctionality for semiconductor devices. In order to achieve these characteristics, structures within semiconductor devices are becoming increasingly complex and integrated.

### SUMMARY

Some aspects of the present disclosure provide semiconductor devices that includes a separation pattern while allowing sufficient removal of a substrate until a dummy source/drain pattern is exposed during a back wiring process, smoothly forming a through-via within a gate cutting pattern, and reducing dispersion of the through-via to allow smoother contact between the through-via and the lower source/drain contact.

A semiconductor device according some implementations of the present disclosure includes: an active pattern spaced apart in a first direction, and extending in a second direction different from the first direction; a lower channel pattern and a lower source/drain pattern located on the active pattern and alternately arranged in the second direction; an upper channel pattern on the lower channel pattern, and an upper source/drain pattern on the lower source/drain pattern; a gate pattern extending in the first direction and located on the lower channel pattern and the upper channel pattern; a separation pattern located between one of the lower source/drain pattern and the upper source/drain pattern and another of the lower source/drain pattern and the upper source/drain pattem in the second direction; and a gate cutting pattern extending in the second direction across the gate pattern to separate the gate pattern; wherein in a third direction different from the first and second directions, a level of the lower end of the separation pattem is higher than a level of the lower end of the gate cutting pattern.

A semiconductor device according to some implementations of the present disclosure includes: an active pattern spaced apart in a first direction, and extending in a second direction different from the first direction; a lower channel pattern and a lower source/drain pattern located on the active pattern and alternately arranged in the second direction; an upper channel pattern on the lower channel pattern, and an upper source/drain pattern on the lower source/drain pattern; a gate pattern extending in the first direction and located on the lower channel pattern and the upper channel pattern; a gate cutting pattern extending in the second direction across the gate pattern to separate the gate pattern; and a through-via located within the gate cutting pattern and extending in the second direction and the third direction along the gate cutting pattern; wherein the through-via has a first via portion extending in the second direction and extending from the lower end to the upper end of the through-via in the third direction, and a second via portion and a third via portion which are located on one side of the first via portion in the first direction and are alternately arranged in the second direction, and a level of the lower end of the third via portion in the third direction is higher than levels of the lower portions of the first via portion and the second via portion.

A semiconductor device according to some implementations of the present disclosure includes: an active pattern spaced apart in a first direction, and extending in a second direction different from the first direction; a lower channel pattern and a lower source/drain pattern located on the active pattern and alternately arranged in the second direction; an upper channel pattern on the lower channel pattern, and an upper source/drain pattern on the lower source/drain pattern; a gate pattern extending in the first direction and located on the lower channel pattern and the upper channel pattern; a separation pattern located between one of the lower source/drain pattern and the upper source/drain pattern and another of the lower source/drain pattern and the upper source/drain pattern in the second direction; and a gate cutting pattern extending in the second direction across the gate pattern to separate the gate pattern; wherein a portion of the above separation pattern extends in the first direction and is inserted into the gate cutting pattern.

Some implementations of the semiconductor devices described herein have structures that are compatible with, or provide, sufficient removal of a substrate until a dummy source/drain pattern is exposed during a back wiring process while including a separation pattern, smooth formation of a through-via within a gate cutting pattern, and reduction in the dispersion of the through-via to more smoothly contact the through-via and the lower source/drain contact.

At least some of the above and other features of the invention are set out in the claims.

### BRIEF DESCRIPTION OF THE DRAWINGS

FIG. 1 is a plan view illustrating an example of a semiconductor device.
FIG. 2 is a cross-sectional view taken along lines A-A' and D-D' of FIG. 1.
FIG. 3 is a cross-sectional view taken along line B-B' of FIG. 1.
FIG. 4 is a cross-sectional view taken along line C-C' of FIG. 1.
FIG. 5 is a plan view showing an example of a semiconductor device.
FIG. 6 is a cross-sectional view taken along line C-C' of FIG. 5.
FIG. 7 is a plan view showing an example of a semiconductor device.
FIG. 8 is a cross-sectional view taken along line C-C' of FIG. 7.
FIG. 9 is a plan view showing an example of a semiconductor device.
FIG. 10 is a cross-sectional view taken along line C-C' of FIG. 9.
FIG. 11 is a plan view showing an example of a semiconductor device.
FIG. 12 is a cross-sectional view taken along lines A-A' and D-D' of FIG. 11.
FIG. 13 is a cross-sectional view taken along line C-C' of FIG. 11.
FIGS. 14 to 48 are cross-sectional views showing an example of a method of manufacturing a semiconductor device.

### DETAILED DESCRIPTION

The present disclosure will be described more fully hereinafter with reference to the accompanying drawings, in which examples according to the present disclosure are shown. As those skilled in the art would realize, the described examples may be modified in various different ways, all without departing from the scope of the present disclosure.

Like reference numerals designate like elements throughout the specification.

In the drawings, the thickness and sizes of layers, regions, etc., may be exaggerated or modified for clarity.

It will be understood that when an element such as a layer, film, region, or substrate is referred to as being "on" another element, it can be directly on the other element or intervening elements may also be present. In contrast, when an element is referred to as being "directly on" or "adjacent to" another element, there are no intervening elements present. The word "on" or "above" means being disposed on or below the object portion, and does not necessarily mean being disposed on the upper side of the object portion based on a gravitational direction.

In addition, in this specification, the phrase "on a plane" means viewing a target portion from the top, and the phrase "on a cross-section" means viewing a cross-section formed by vertically cutting a target portion from the side.

Additionally, throughout the specification, two directions parallel to and intersecting the upper end (e.g., surface) of the substrate are defined as a first direction D1 and a second direction D2, respectively, and the direction perpendicular to the upper end of the substrate is described as a third direction D3. For example, the first direction D1 and the second direction D2 can be orthogonal to each other. The first direction D1 and the second direction D2 can be in a common plane, e.g., a common lateral plane corresponding to a surface of a substrate included in a device or on/from which the device was fabricated.

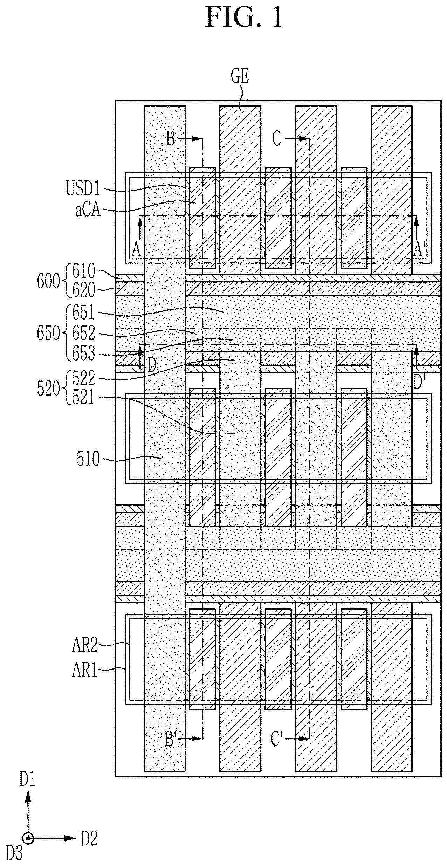

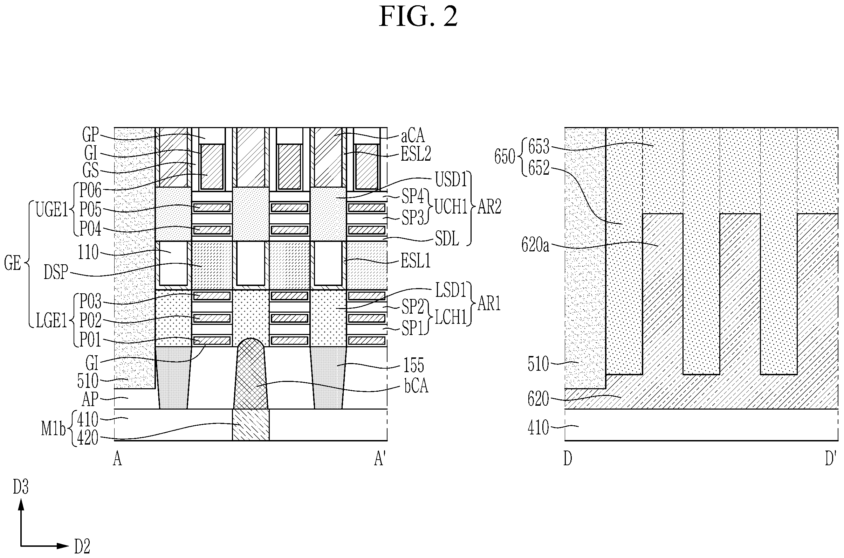

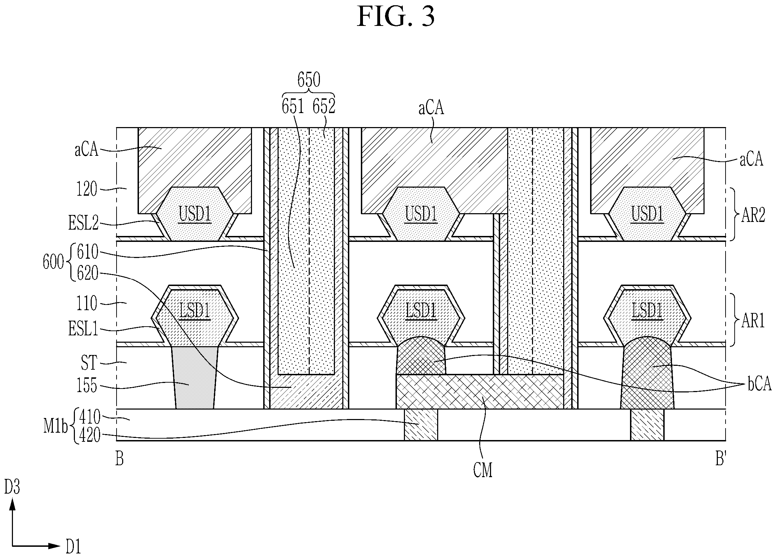

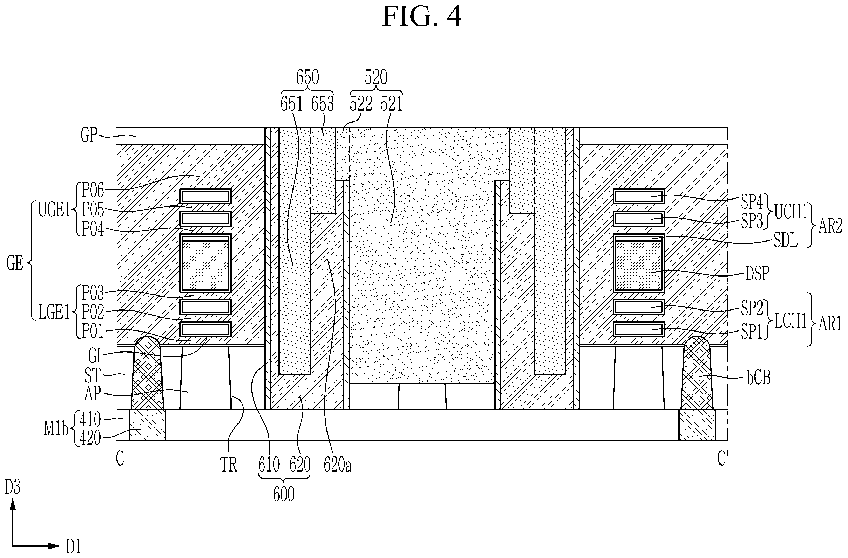

FIG. 1 is a plan view illustrating a semiconductor device. FIG. 2 is a cross-sectional view taken along lines A-A' and D-D' of FIG. 1. FIG. 3 is a cross-sectional view taken along line B-B' of FIG. 1. FIG. 4 is a cross-sectional view taken along line C-C' of FIG. 1.

For clear understanding and simple illustration, FIG. 1 mainly illustrate a first active region AR1, a second active region AR2, a gate pattern GE, an upper source/drain pattern USD1, an upper source/drain contact aCA, a gate cutting pattern 600, a separation pattern 520, and a separation structure 510.

For example, the semiconductor device may be a three-dimensional semiconductor device (e.g., a stacked transistor). In other words, transistors can be stacked in the third direction D3 in a cell region, e.g., in the active regions. For example, a single height cell (SHC) may be located between the first power wiring and the second power wiring, and the single height cell may include a first active region AR1 as a bottom tier, and a second active region AR2 may be stacked as a top tier over the first active region AR1.

For example, NMOSFETs in the first active region AR1 may be located on the active pattern AP, and PMOSFETs in the second active region AR2 may be stacked on the NMOSFETs. The first active region AR1 and the second active region AR2 may be spaced apart from each other in the third direction D3.

In other words, the three-dimensional semiconductor device may have a first active region AR1 and a second active region AR2 that overlap along a third direction D3. Accordingly, the semiconductor device of FIG. 1 provides an improved degree of integration by reducing the area of the logic cell.

In some implementations, a peripheral region in which transistors constituting a processor core or an I/O terminal are arranged may be located around the cell region. For example, the peripheral region may be the core/periphery region. As an example, the peripheral region may include a long-gate transistor (or long-channel transistor) having a relatively long gate length (i.e., channel length). Transistors in the peripheral region can operate at higher power than transistors in the cell region. For example, the transistors in the cell region may be single gate (SG) devices, and the transistors in the peripheral region may be extra gate (EG) devices.

An active pattern AP (labeled in FIGS. 2 and 4) can be defined by a trench TR in the cell region. For example, the active pattern AP may be a portion that protrudes vertically in the third direction D3. On a plane (e.g., in a plan view), the active pattern AP may have a bar shape, for example, having portions spaced apart in a first direction D1 and extending in a second direction D2. First and second active regions (AR1, AR2) can be sequentially stacked on an active pattern AP.

For example, the active pattern AP may include a semiconductor material such as silicon, germanium, or silicon germanium, and may include, for example silicon. In some implementations, the active pattern AP is replaced with silicon oxide after removing the substrate 100 to form a lower source/drain contact bCA (labeled in FIGS. 2-3), as described below, and thus the active pattern AP may include silicon oxide.

A device isolation layer ST can fill the trench between the active patterns AP. For example, the device isolation layer ST may include silicon oxide. The upper end of the device isolation layer ST may be coplanar with the upper end of the active pattern AP, or the level of the upper end of the device isolation layer ST in the third direction D3 may be lower than the level of the upper end of the active pattern AP. The device isolation layer ST may not cover the lower channel pattern LCH1 described later.

A first active region AR1 including a lower channel pattern LCH1 and a lower source/drain pattern LSD1 can be located on the active pattern AP. A lower channel pattern LCH1 may be interposed between one lower source/drain pattern LSD1 and another lower source/drain pattern LSD1 spaced apart from the lower source/drain pattern LSD1 in a second direction D2. The lower channel pattern LCH1 may connect a pair of lower source/drain patterns LSD1 to each other. For example, the lower channel pattern LCH1 and the lower source/drain pattern LSD1 may be alternately arranged in the second direction D2.

The lower channel pattern LCH1 may include a first semiconductor pattern SP1 and a second semiconductor pattern SP2 that are stacked and spaced apart from each other in the third direction D3. However, the present disclosure is not limited thereto, and the lower channel pattern LCH1 may include three or more semiconductor patterns. Each of the first semiconductor pattern SP1 and the second semiconductor pattern SP2 may include silicon (Si), germanium (Ge), or silicon germanium (SiGe). For example, each of the first semiconductor pattern SP1 and the second semiconductor pattern SP2 may include crystalline silicon.

The lower source/drain pattern LSD1 may be located on the upper end or surface of the active pattern AP. The lower source/drain pattern LSD1 may be an epitaxial pattern formed through a selective epitaxial growth (SEG) process. For example, the upper end of the lower source/drain pattern LSD1 may be higher than the upper end of the second semiconductor pattern SP2 of the lower channel pattern LCH1.

The lower source/drain pattern LSD1 may be doped with impurities to have a first conductivity type. The first conductivity type may be N-type or P-type. As an example, the first conductivity type may be N-type. The lower source/drain pattern LSD1 may include silicon (Si) or silicon germanium (SiGe).

A dummy source/drain pattern 155 may be located under the lower source/drain pattern LSD1. The dummy source/drain pattern 155 may penetrate at least a portion of the active pattern AP. For example, a dummy source/drain pattern 155 may be embedded within the active pattern AP. The dummy source/drain pattern 155 may be located under at least one lower source/drain pattern LSD1 among the plurality of lower source/drain patterns LSD1.

For example, the dummy source/drain pattern 155 may include the same material as the lower source/drain pattern LSD1. For example, the dummy source/drain pattern 155 may include silicon (Si) or silicon germanium (SiGe), and may further include carbon (C), silicon (Si), germanium (Ge), or tin (Sn).

As described below, when removing the substrate 100 to form a lower source/drain contact bCA, as the substrate 100 is removed until the dummy source/drain pattern 155 is exposed, the lower end of the dummy source/drain pattern 155 may have a flat shape and can come into contact with the lower wiring structure M1b.

A first interlayer stop film ESL1 may be located on the lower source/drain pattern LSD1. For example, the first interlayer stop film ESL1 may cover the lower source/drain pattern LSD1.

A first interlayer insulating layer 110 may be located on the first interlayer stop film ESL1. The first interlayer insulating layer 110 may cover the lower source/drain pattern LSD1.

For example, the first interlayer insulating layer 110 may include silicon oxide (SiO2), silicon nitride (SiN), silicon oxynitride (SiON), or a low-k material.

The first interlayer stop film ESL1 may include a material having an etch selectivity with respect to the first interlayer insulating layer 110. The first interlayer stop film ESL1 may include, for example, silicon nitride (SiN), silicon oxynitride (SiON), silicon carbonitride (SiOCN), silicon boron nitride (SiBN), silicon oxyboron nitride (SiOBN), or silicon oxycarbide (SiOC).

The second active region AR2 may be located over the first active region AR1. The second active region AR2 may include an upper channel pattern UCH1 and an upper source/drain pattern USD1.

The upper channel pattern UCH1 may be located on the lower channel pattern LCH1. The upper source/drain pattern USD1 may be located on the lower source/drain pattern LSD1. For example, the upper channel pattern UCH1 may overlap the lower channel pattern LCH1 along the third direction D3. The upper source/drain pattern USD1 may be overlapped with the lower source/drain pattern LSD1 in the third direction D3. The upper channel pattern UCH1 may be interposed between one upper source/drain pattern USD1 and another upper source/drain pattern USD1 spaced apart from the upper source/drain pattern in the second direction D2. The upper channel pattern UCH1 may connect a pair of upper source/drain patterns USD1 to each other. For example, the upper channel pattern UCH1 and the upper source/drain pattern USD1 may be alternately arranged in the second direction D2.

The upper channel pattern UCH1 may include a third semiconductor pattern SP3 and a fourth semiconductor pattern SP4 that are stacked and spaced apart from each other in the third direction D3. However, the present disclosure is not limited thereto, and the upper channel pattern UCH1 may include three or more semiconductor patterns. The third semiconductor pattern SP3 and the fourth semiconductor pattern SP4 of the upper channel pattern UCH1 may include the same semiconductor material as the first and second semiconductor patterns SP1 and SP2 of the lower channel pattern LCH1 described above.

At least one intermediate insulating structure DSP may be interposed between the lower channel pattern LCH1 and the upper channel pattern UCH1 thereon, and at least one dummy channel pattern SDL may be interposed between the first to fourth semiconductor patterns SP1, SP2, SP3, and SP4.

For example, the intermediate insulating structure DSP may be located between the lower channel pattern LCH1 and the upper channel pattern UCH1, and a dummy channel pattern SDL may be interposed between the intermediate insulating structure DSP and the third semiconductor pattem SP3 of the upper channel pattern UCH1.

For example, the second semiconductor pattern SP2 of the lower channel pattern LCH1, the third sub-gate portion PO3 of the lower gate pattern LGE1, the intermediate insulating structure DSP, the dummy channel pattern SDL, the fourth sub-gate portion PO4 of the upper gate pattern UGE1, and the third semiconductor pattern SP3 of the upper channel pattern UCH1 may be sequentially stacked in the third direction D3.

The intermediate insulating structure DSP may include a semiconductor material such as silicon (Si), germanium (Ge), or silicon germanium (SiGe), or a silicon-based insulating material such as silicon oxide or silicon nitride. For example, the intermediate insulating structure DSP may include a silicon-based insulating material.

The dummy channel pattern SDL may include a semiconductor material such as silicon (Si), germanium (Ge), or silicon germanium (SiGe), or a silicon-based insulating material such as silicon oxide or silicon nitride.

The upper source/drain pattern USD1 may be located on the upper surface of the first interlayer insulating layer 110. The upper source/drain pattern USD1 may be an epitaxial pattern formed through a selective epitaxial growth (SEG) process. For example, the upper end of the upper source/drain pattern USD1 may be higher than the upper end of the fourth semiconductor pattern SP4 of the upper channel pattern UCH1.

The upper source/drain pattern USD1 may be doped with impurities to have a second conductivity type. The second conductivity type may be different from the first conductivity type of the lower source/drain pattern LSD1. As an example, the second conductivity type may be P-type. The upper source/drain pattern USD1 may include silicon germanium (SiGe) or silicon (Si).

A second interlayer stop film ESL2 may be located on the upper source/drain pattern USD1. For example, the second interlayer stop film ESL2 may cover the upper source/drain pattern USD1.

The second interlayer stop film ESL2 may cover both side surfaces in the first direction D1 of the upper source/drain pattern USD1. The second interlayer stop film ESL2 may not be located between the upper source/drain pattern USD1 and the upper source/drain contact aCA. For example, the upper source/drain pattern USD1 and the upper source/drain contact aCA may be directly in contact.

A second interlayer insulating layer 120 may be located on the second interlayer stop film ESL2. The second interlayer insulating layer 120 may cover the upper source/drain pattern USD1.

For example, the second interlayer insulating layer 120 may include silicon oxide (SiO₂), silicon nitride (SiN), silicon oxynitride (SiON), or a low-k material.

The second interlayer stop film ESL2 may include a material having an etch selectivity with respect to the second interlayer insulating layer 120. The second interlayer stop film ESL2 may include, for example, silicon nitride (SiN), silicon oxynitride (SiON), silicon carbonitride (SiOCN), silicon boron nitride (SiBN), silicon oxyboron nitride (SiOBN), or silicon oxycarbide (SiOC).

The gate pattern GE may be located on the lower channel pattern LCH1 and the upper channel pattern UCH1. On a plane, or in a plan view (e.g., as shown in FIG. 1), the gate pattern GE may have a bar shape (e.g., rectangular shape) extending in the first direction D1. A portion of the gate pattern GE may be overlapped with the stacked lower channel pattern LCH1 and upper channel pattern UCH1 in the third direction D3.

The gate pattern GE can extend in a third direction D3 from the upper end of the device isolation layer ST or the upper end of the active pattern AP to the gate capping pattern GP described later. The gate pattern GE may extend in a third direction D3 from the lower channel pattern LCH1 of the first active region AR1 to the upper channel pattern UCH1 of the second active region AR2. For example, the gate pattern GE can extend in the third direction D3 from the first semiconductor pattem SP1 at the bottom to the fourth semiconductor pattern SP4 at the top.

The gate pattern GE may be located on the upper end, bottom surface, and both side surfaces of each of the first semiconductor pattern SP1, the second semiconductor pattern SP2, the third semiconductor pattern SP3, and the fourth semiconductor pattern SP4. For example, the logic cell may include a three-dimensional field-effect transistor (e.g., an MBCFET or a GAAFET) in which the gate pattern GE surrounds the channel three-dimensionally.

The gate pattern GE may have a lower gate pattern LGE1 located within the first active region AR1 and an upper gate pattern UGE1 located within the second active region AR2. The lower gate pattern LGE1 and the upper gate pattern UGE1 may be overlapped with each other in the third direction D3. The lower gate pattern LGE1 and the upper gate pattern UGE1 may be connected to each other. For example, the gate pattern GE may be a common gate electrode in which the lower gate pattern LGE1 on the lower channel pattern LCH1 and the upper gate pattern UGE1 on the upper channel pattern UCH1 are connected to each other.

The lower gate pattern LGE1 may have a first sub-gate portion PO1 interposed between the active pattern AP and the first semiconductor pattern SP1, a second sub-gate portion PO2 interposed between the first semiconductor pattern SP1 and the second semiconductor pattern SP2, and a third sub-gate portion PO3 interposed between the second semiconductor pattern SP2 and the intermediate insulating structure DSP.

The upper gate pattern UGE1 may have a fourth sub-gate portion PO4 interposed between the dummy channel pattern SDL and the third semiconductor pattern SP3, a fifth sub-gate portion PO5 interposed between the third semiconductor pattern SP3 and the fourth semiconductor pattern SP4, and a sixth sub-gate portion PO6 located on the fourth semiconductor pattern SP4.

For example, the lower gate pattern LGE1 may include a first work function metal pattern located on the first and second semiconductor patterns SP1 and SP2. The upper gate pattern UGE1 may include a second work function metal pattern located on the third and fourth semiconductor patterns SP3 and SP4. Each of the first and second work function metal patterns may include a metal including titanium (Ti), tantalum (Ta), aluminum (Al), tungsten (W), molybdenum (Mo), or a combination thereof, and nitrogen (N). The first and second work function metal patterns may have different work functions. The gate pattern GE may include, for example a low-resistance metal including tungsten (W), ruthenium (Ru), aluminum (Al), titanium (Ti), tantalum (Ta), or a combination thereof on the first and second work function metal patterns.

A gate insulating layer GI may be interposed between the gate pattern GE and the first to fourth semiconductor patterns SP1 to SP4. The gate insulating layer may include a silicon oxide film, a silicon oxynitride film, a high-k dielectric film, or a combination thereof. As an example, the gate insulating film GI may include a silicon oxide film directly covering the surfaces of the first to fourth semiconductor patterns SP1 to SP4 and a high-k dielectric film located on the silicon oxide film. In other words, the gate insulating layer GI may include a multi-layer of a silicon oxide layer and a high-k dielectric layer.

The high dielectric film may include a high dielectric constant material that has a higher dielectric constant than the silicon oxide film. As an example, the high dielectric constant material may include hafnium oxide, hafnium silicon oxide, hafnium zirconium oxide, hafnium tantalum oxide, lanthanum oxide, zirconium oxide, zirconium silicon oxide, tantalum oxide, titanium oxide, barium strontium titanium oxide, barium titanium oxide, and strontium titanium oxide, lithium oxide, aluminum oxide, lead scandium tantalum oxide, lead zinc niobate, or a combination thereof.

In some implementations, a gate inner spacer is located between the gate pattern GE and the lower source/drain pattern LSD1 and the upper source/drain pattern USD1. For example, the gate inner spacer may be located between the first to third sub-gate portions PO1 to PO3 of the lower gate pattern LGE1 and the lower source/drain pattern LSD1, and may be located between the fourth and fifth sub-gate portions PO4 and PO5 of the upper gate pattern UGE1 and the upper source/drain pattern USD1.

For example, when viewed in cross-section, the gate inner spacer may be located on each side of the first to fifth sub-gate portions PO1 to PO5 in the second direction D2.

For example, the gate inner spacer may include a low-k material. The low-k material may include silicon oxide, or a material having a lower dielectric constant than silicon oxide. For example, the low-k material may include silicon oxide, silicon oxide doped with fluorine or carbon, porous silicon oxide, or an organic polymeric dielectric.

A pair of gate spacers GS (labeled in FIG. 2) may be respectively arranged on both side surfaces of the sixth sub-gate portion PO6 of the gate pattern GE in the second direction D2. The gate spacers GS can extend in a first direction D1 along the gate pattern GE.

The upper ends of the gate spacers GS may be higher than the upper ends of the gate pattern GE. The upper ends of the gate spacers GS may be coplanar with the upper end of the second interlayer insulating layer 120.

The gate spacers GS may include SiCN, SiOCN, SiN, or a combination thereof. For example, the gate spacers GS may include multi-layers each including SiCN, SiOCN, SiN, or a combination thereof.

A gate capping pattern GP may be located on the upper end of the gate pattern GE. The gate capping pattern GP may extend in the first direction D1 along the gate pattern GE. For example, the gate capping pattern GP may include SiON, SiCN, SiOCN, SiN, or a combination thereof.

The gate cutting pattern 600 may be located between one active pattern AP and another active pattern AP spaced apart from the active pattern in the first direction D1. For example, the gate cutting pattern 600 may be alternately arranged with the active pattern AP in the first direction D1. The gate cutting pattern 600 may be spaced apart from the active pattern AP in the first direction D1, and a device isolation layer ST may be located between the gate cutting pattern 600 and the active pattern AP.

The gate cutting pattern 600 can extend in the second direction D2. For example, in a plane or a plan view (e.g., FIG. 1), the gate cutting pattern 600 may have a bar shape (e.g., rectangular shape) having portions spaced apart from one another in a first direction D1 and extending in a second direction D2.

The gate cutting pattern 600 can extend in the third direction D3. For example, the gate cutting pattern 600 may extend in the third direction D3 from a level lower than the lower end of the gate pattern GE to a level higher than the upper end of the gate pattern GE. For example, the lower end of the gate cutting pattern 600 may be located closer to the lower end of the active pattern AP in the third direction D3 than the lower end of the gate pattern GE.

For example, the level of the lower end of the gate cutting pattern 600 in the third direction D3 (or vertical level) may be lower than the level of the upper end of the active pattern AP and lower than the level of the lower end of the separation pattern 520 described later, lower than the level of the lower end of a through-via 650 described later, and higher than or substantially equal to the level of the lower end of the dummy source/drain pattern 155. The lower end of the gate cutting pattern 600 may be in contact with the upper end of the lower wiring structure M1b.

The gate cutting pattern 600 may be located between one lower gate pattern LGE1 and another lower gate pattern LGE1 spaced apart from the lower gate pattern in the first direction D1. Additionally, the gate cutting pattern 600 may be located between one upper gate pattern UGE1 and another upper gate pattern UGE1 spaced apart from the upper gate pattern in the first direction D1.

Accordingly, one gate pattern GE may be separated from another gate pattern GE, spaced apart in the first direction D1 from the one gate pattern GE, by a gate cutting pattern 600. For example, the gate cutting pattern 600 may extend in the second direction D2 across the gate pattern GE, and the gate cutting pattern 600 and may penetrate the lower gate pattern LGE1 and the upper gate pattern UGE1 of the gate pattern GE. Accordingly, the connection of the gate pattern GE may be cut by the gate cutting pattern 600.

The gate cutting pattern 600 may be located between one lower source/drain pattern LSD1 and another lower source/drain pattern LSD1 spaced apart from the one lower source/drain pattern LSD1 in the first direction D1. The gate cutting pattern 600 may be located between one upper source/drain pattern USD1 and the upper source/drain pattern USD1.

Additionally, the gate cutting pattern 600 may be located between the lower source/drain contact bCA and another lower source/drain contact bCA spaced apart from it in the first direction D1. The gate cutting pattern 600 may be located between a lower gate contact bCB in the first direction D1 and another lower gate contact bCB spaced apart from the lower gate contact bCB in the first direction D1.

Meanwhile, as described later, since the separation pattern 520 is formed at a position where the gate pattern GE, the lower channel pattern LCH1, and the upper channel pattern UCH1 are removed after the gate pattern GE, the lower channel pattern LCH1, and the upper channel pattern UCH1 are removed by the gate cutting pattern 600, the gate cutting pattern 600 may be located between the gate pattern GE and the separation pattern 520 in the first direction D1. For example, a separation pattern 520 may be located between one gate cutting pattern 600 and another gate cutting pattern 600 spaced apart from the one gate cutting pattern 600 in the first direction D1.

As an example, as shown in FIG. 4, the gate cutting pattern 600 may include a gapfill insulating layer 620 and an insulating liner 610 located on both sides of the gapfill insulating layer 620 in the first direction D1.

The gapfill insulating layer 620 may be located to fill the internal space of the gate cutting pattern 600. The gapfill insulating layer 620 may be located approximately at the center of the gate cutting pattern 600 in the first direction D1.

Portions of the insulating liner 610 may be separated from each other on both sides of the gapfill insulating layer 620 in the first direction D1. For example, in the first direction D1, the insulating liner 610 may be located between the gate pattern GE and the gapfill insulating layer 620, and may be located between the separation pattern 520 and the gapfill insulating layer 620.

The gate cutting pattern 600 may include an insulating material. For example, the gate cutting pattern 600 may include silicon oxide, silicon nitride, silicon oxynitride, a high-k material having a higher dielectric constant than silicon oxide, or a combination thereof.

For example, the gapfill insulating layer 620 and the insulating liner 610 constituting the gate cutting pattern 600 may include different materials. For example, the gapfill insulating layer 620 may include silicon oxide, and the insulating liner 610 may include silicon nitride. However, this is only one example, and the materials of the gapfill insulating layer 620 and the insulating liner 610 may be changed in various ways.

The through-via 650 may be located within the gate cutting pattern 600.

The through-via 650 may extend in the third direction D3 to penetrate all or at least a portion of the gate cutting pattern 600. The upper portion of the through-via 650 can be connected to an upper source/drain contact aCA, and the lower portion of the through-via 650 may be connected to a lower source/drain contact bCA. Accordingly, the through-via 650 may connect between the upper source/drain contact aCA and the lower source/drain contact bCA. Additionally, the through-via 650 may be connected to the lower wiring structure M1b.

For example, the through-via 650 may extend in the third direction D3 from a level higher than the lower end of the gate cutting pattern 600 to a level lower than or substantially the same as the upper end of the gate cutting pattern 600. For example, the lower end of the through-via 650 may be located further from the lower end of the active pattern AP in the third direction D3 than the lower end of the gate cutting pattern 600.

Additionally, the level of the lower end of the through-via 650 in the third direction D3 may be lower than the level of the upper end of the active pattern AP, higher than the level of the lower end of the gate cutting pattern 600, higher than the level of the lower end of the separation pattern 520, and higher than the level of the lower end of the dummy source/drain pattern 155. The lower end of the through-via 650 may not be in contact with the upper end of the lower wiring structure M1b. A connecting portion CM described later may be located between the through-via 650 and the lower wiring structure M1b.

The through-via 650 may extend in the second direction D2 along the gate cutting pattern 600. For example, in one plane, or in a plan view (e.g., as shown in FIG. 1), the through-via 650 may have a bar shape that is spaced apart in a first direction D1 and extends in a second direction D2. Multiple through-via may be spaced apart from one another in the first direction D1. Accordingly, the through-via 650 may extend in the second direction D2 across the gate pattern GE, and the through-via 650 can penetrate the lower gate pattern LGE1 and the upper gate pattern UGE1 of the gate pattern GE.

The through-via 650 may be located approximately at the center portion of the gate cutting pattern 600 in the first direction D1. The insulating liner 610 of the gate cutting pattern 600 may be separated from each other on both sides of the first direction D1 of the through-via 650. The gapfill insulating layer 620 of the gate cutting pattern 600 may be located to fill the internal space between the through-via 650 and the insulating liner 610.

In some implementations, the through-via 650 includes a conductive pattern and a barrier pattern surrounding the conductive pattern. For example, the conductive pattern may include a metal including aluminum, copper, tungsten, molybdenum, or a combination thereof. The barrier pattern may cover the side walls and bottom surface of the conductive pattern. The barrier pattern may include a metal film or a metal nitride film. The metal film may include titanium, tantalum, tungsten, nickel, cobalt, platinum, or combinations thereof. The metal nitride film may include titanium nitride (TiN), tantalum nitride (TaN), tungsten nitride (WN), nickel nitride (NiN), cobalt nitride (CoN), platinum nitride (PtN), or a combination thereof.

For example, the through-via 650 may have first to third via portions 651, 652, and 653.

The first via portion 651 may extend in a second direction D2 and may extend from the lower end to the upper end of the through-via 650 in a third direction D3. For example, the first via portion 651 can extend in the third direction D3 from a level higher than the lower end of the gate cutting pattern 600 to a level lower than or substantially the same as the upper end of the gate cutting pattern 600.

The first via portion 651 can extend in the second direction D2 along the gate cutting pattern 600. For example, in one plane (e.g., FIG. 1), the first via portion 651 may have a bar shape extending in the second direction D2.

The second via portion 652 and the third via portion 653 can be located on one side of the first via portion 651 in the first direction D2. For example, the second via portion 652 and the third via portion 653 may be located on the surface of the first via portion 651 facing the separation pattern 520.

The second via portion 652 and the third via portion 653 may be alternately arranged in the second direction D2. As the first via portion 651 extends in the second direction D2, it passes through the separation pattern 520 and the upper source/drain pattern USD1 alternately arranged in the second direction D2. At this time, the second via portion 652 may be located between the first via portion 651 and the upper source/drain pattern USD1, and the third via portion 653 may be located between the first via portion 651 and the separation pattern 520. The third via portion 653 may be in contact with the separation pattern 520, and for example, may be in contact with the protrusion portion 522 of the separation pattern 520 described below.

The second via portion 652 may extend from the lower end to the upper end of the through-via 650 in the third direction D3, and the third via portion 653 may extend from the middle to the upper end of the through-via 650 in the third direction D3. For example, the level of the lower end of the third via portion 653 in the third direction D3 may be higher than the levels of the lower ends of the first via portion 651 and the second via portion 652. The level of the upper end of the third via portion 653 in the third direction D3 may be substantially the same as the levels of the upper ends of the first via portion 651 and the second via portion 652. Accordingly, the length of the third via portion 653 in the third direction D3 may be shorter than the lengths of the first via portion 651 and the second via portion 652.

Meanwhile, since the through-via 650 is located within the gate cutting pattern 600 and the inside of the gate cutting pattern 600 is filled with the gapfill insulating layer 620, the through-via 650 may be surrounded by the gapfill insulating layer 620.

For example, the gapfill insulating layer 620 may be located on one side of the first via portion 651 in the first direction D1 and may be located between the first via portion 651 and the insulating liner 610 on one side. The gapfill insulating layer 620 may be located on the other side of the second via portion 652 and the third via portion 653 in the first direction D1, and may be located between the second via portion 652 and the third via portion 653 and the insulating liner 610 on the other side. The gapfill insulating layer 620 may be located under the first and second via portions 651 and 652 in the third direction D3 and may be located between the first and second via portions 651 and 652 and the lower wiring structure M1b.

Additionally, the gapfill insulating layer 620 may have an insertion portion 620a located under the third via portion 653 in the third direction D3. As described above, since the length of the third via portion 653 in the third direction D3 is shorter than the length of the second via portion 652, a portion of the through-via 650 is not located under the third via portion 653 and can be filled with the insertion portion 620a of the gapfill insulating layer 620. In addition, as the second via portion 652 and the third via portion 653 are alternately arranged in the second direction D2, the insertion portion 620a of the gapfill insulating layer 620 can also be alternately arranged with the second via portion 652 in the second direction D2.

For example, when the gate cutting pattern 600 includes a gapfill insulating layer 620 including an oxide and an insulating liner 610 including a nitride, as described below, the etching of the gate cutting pattern 600 to form the through-via 650 within the gate cutting pattern 600 may be smoothly performed.

At this time, due to the difference in etching rates between the gapfill insulating layer 620 and the insulating liner 610, a portion of the separation pattern 520, for example, a protrusion portion 522 of the separation pattern 520, may be formed within the gate cutting pattern 600.

Accordingly, when etching the gate cutting pattem 600 to form the through-via 650, relatively more (e.g., deeper) etching is performed at a location where the protrusion portion 522 of the separation pattern 520 is not inserted, so that a second via portion 652 having a relatively deep depth in the third direction D3 is formed, and at a location where the protrusion portion 522 of the separation pattern 520 is inserted, since the separation pattern 520 is etched together with the gate cutting pattern, relatively less (e.g., shallower) etching is performed, so that a third via portion 653 having a relatively shallow depth in the third direction D3 may be formed.

In addition, as the separation pattern 520 is spaced apart in the second direction D2, the second via portion 652 and the third via portion 653 of the through-via 650 are also alternately located in the second direction D2, and when viewed in cross-section (for example, FIG. 2), the boundary between the through-via 650 and the gapfill insulating layer 620 may have an uneven wave shape in the third direction D3 while following the second direction D2.

Additionally, a portion of the separation pattern 520 inserted into the gate cutting pattern 600, for example, a protrusion portion 522 of the separation pattern 520, may be in contact with the through-via 650, for example, a third via portion 653 of the through-via 650.

The separation pattern 520 may be located between one lower source/drain pattern LSD1 and another lower source/drain pattern LSD1 spaced apart from the one lower source/drain pattern LSD2 in a second direction D2. Additionally, the separation pattern 520 may be located between one upper source/drain pattern USD1 and another upper source/drain pattern USD1 spaced apart from the one upper source/drain pattern USD1 in the second direction D2.

For example, the separation pattern 520 may be alternately arranged with the lower source/drain pattern LSD1 in the second direction D2. Additionally, the separation pattern 520 may be alternately arranged with the upper source/drain pattern USD1 in the second direction D2.

The separation pattern 520 may be located between an upper source/drain contact aCA and another upper source/drain contact aCA spaced apart from the upper source/drain contact in the second direction D2. Additionally, the separation pattern 520 may be located between the lower source/drain contact bCA and another lower source/drain contact bCA spaced apart from the lower source/drain contact bCA in the second direction D2.

The separation pattern 520 may be located between gate pattems GE separated by a gate cutting pattern 600 in the first direction D1. For example, the gate cutting pattern 600 may be located between the gate pattern GE and the separation pattern 520 in the first direction D1.

The separation pattern 520 may be formed at a location where the gate pattern GE, the lower gate pattern LGE1, and the upper gate pattern UGE1 are removed after removing at least a portion of the gate pattern GE, the lower gate pattern LGE1, and the upper gate pattern UGE1 cut by the gate cutting pattern 600. For example, a separation pattern 520 may be located between one gate cutting pattern 600 and another gate cutting pattern 600 spaced apart from the first direction D1. A separation pattern 520 may extend in the first direction D1 from one gate cutting pattern 600 to another gate cutting pattern 600 spaced apart from the one gate cutting pattern 600 in the first direction D1.

Additionally, the separation pattern 520 may be located on the same line as the gate pattern GE. In other words, the separation pattern 520 and the gate pattern GE may be overlapped in the first direction D1, and the width of the separation pattern 520 in the second direction D2 may be similar to or substantially the same as the width of the gate pattern GE in the second direction D2.

The separation pattern 520 may extend in the first direction D1 parallel to the gate pattern GE. For example, in one plane (e.g., FIG. 1), the separation pattern 520 may have a bar shape and may include portions that are spaced apart from one another in the second direction D2 and extend in the first direction D1.

The separation pattern 520 may be located on the active pattern AP.

However, the level of the upper end of the active pattern AP located under the separation pattern 520 in the third direction D3 may be lower than the level of the upper end of the active pattern AP located under the gate pattern GE. Accordingly, the level of the lower end of the separation pattern 520 in the third direction D3 may be lower than the level of the lower end of the gate pattern GE.

The separation pattern 520 may extend in the third direction D3. For example, the separation pattern 520 may extend in the third direction D3 from a level lower than the lower end of the lower source/drain pattern LSD1 to a level higher than the upper end of the upper source/drain pattern USD1. For example, the lower end of the separation pattern 520 may be located closer to the lower end of the active pattern AP in the third direction D3 than the lower end of the lower source/drain pattern LSD1.

For example, the level of the lower end of the separation pattern 520 in the third direction D3 may be lower than the level of the upper end of the active pattern AP, lower than the level of the lower end of the lower source/drain pattern LSD1, higher than the level of the lower end of the dummy source/drain pattern 155, higher than the level of the lower end of the gate cutting pattern 600, and lower than the level of the lower end of the through-via 650.

The separation pattern 520 in the third direction D3 may be spaced apart from the lower wiring structure M1b. In other words, the lower end of the separation pattern 520 may not be in contact with the upper end of the lower wiring structure M1b. The active pattern AP may be located between the separation pattern 520 and the lower wiring structure M1b.

Accordingly, as described below, when removing the substrate 100 to form a lower source/drain contact bCA, the substrate 100 is prevented from being insufficiently removed due to being stopped by the separation pattern 520, and the substrate 100 may be sufficiently removed until the dummy source/drain pattern 155 is revealed.

For example, the separation pattern 520 may include an insulating material. For example, the separation pattern 520 may include silicon oxide, silicon nitride, silicon oxynitride, a high-k material having a higher dielectric constant than silicon oxide, or a combination thereof, and may include silicon nitride.

A portion of the separation pattern 520 may extend in the first direction D1 and inserted into the gate cutting pattern 600.

For example, the separation pattern 520 may have a body portion 521 and a protrusion portion 522, and the protrusion portion 522 of the separation pattern 520 may be inserted into (protrude into) the gate cutting pattern 600.

The body portion 521 may be located next to the gate cutting pattern 600 in the first direction D1. The body portion 521 can be located between one gate cutting pattern 600 and another gate cutting pattern 600 spaced apart from the one gate cutting pattern 600 in the first direction D1. The body portion 521 may extend in the first direction D1 from one gate cutting pattern 600 to another gate cutting pattern 600 spaced apart from the one gate cutting pattern 600 in the first direction D1. The body portion 521 may contact the side wall of the gate cutting pattern 600 in the first direction D1.

The body portion 521 may extend in a third direction D3. For example, the body portion 521 may extend in the third direction D3 from a level lower than the lower end of the lower source/drain pattern LSD1 to a level higher than the upper end of the upper source/drain pattern USD1.

The protrusion portion 522 may protrude from the body portion 521 in a first direction D1.

The protrusion portion 522 may protrude in the first direction D1 from the upper end of the body portion 521. In the third direction D3, the level of the upper end of the protrusion portion 522 may be substantially the same as the level of the upper end of the body portion 521, and the level of the lower end of the protrusion portion 522 may be higher than the level of the lower end of the body portion 521. Accordingly, the separation pattern 520 when viewed in cross-section (e.g., FIG. 4) may have a "T" shape.

As the body portion 521 comes into contact with the side wall of the gate cutting pattern 600 in the first direction D1, the protrusion portion 522 may be inserted into the gate cutting pattern 600. For example, the protrusion portion 522 may overlap with a portion of the gate cutting pattern 600 along the third direction D3. For example, the protrusion portion 522 may be located on the gapfill insulating layer 620 past the insulating liner 610 of the gate cutting pattern 600.

Additionally, the protrusion portion 522 may come into contact with the through-via 650. For example, the protrusion portion 522 may contact the third via portion 653 of the through-via 650. Additionally, the level of the lower end of the protrusion portion 522 may be higher than the level of the lower end of the third via portion 653.

The separation structure 510 may be located on one side of the lower source/drain pattern LSD1 in the second direction D2. Additionally, the separation structure 510 may be located on one side of the upper source/drain pattern USD1 in the second direction D2. The separation structure 510 may be arranged spaced apart from the separation pattern 520 in the second direction D2.

In some implementations, the separation structure 510 is alternately arranged with the lower source/drain pattern LSD1 in the second direction D2. Additionally, the separation structure 510 may be alternately arranged with the upper source/drain pattern USD1 in the second direction D2.

The separation structure 510 may be located on one side of the gate pattern GE in the second direction D2. The separation structure 510 may be formed at that location after removing the gate pattern GE, the lower gate pattern LGE1, and the upper gate pattern UGE1.

The separation structure 510 may extend in a first direction D1 parallel to the gate pattern GE. Accordingly, the separation structure 510 may pass next to a plurality of active patterns AP spaced apart from each other in the first direction D1. For example, in one plane or in a plan view (e.g., FIG. 1), the separation structure 510 may have a bar shape with a direction of longest extent in the first direction D1.

The separation structure 510 may be located on the active pattern AP and may extend in the third direction D3. For example, the separation structure 510 may extend in the third direction D3 from a level lower than the lower end of the lower source/drain pattern LSD1 to a level higher than the upper end of the upper source/drain pattern USD1.

For example, the separation structure 510 may include an insulating material. For example, the separation structure 510 may include silicon oxide, silicon nitride, silicon oxynitride, a high-k material having a higher dielectric constant than silicon oxide, or a combination thereof.

The upper source/drain contact aCA may be electrically connected to the upper source/drain pattern USD1 by penetrating the second interlayer insulating layer 120. Additionally, in some implementations, the upper gate contact is electrically connected to the gate pattern GE through the second interlayer insulating layer 120 and the gate capping pattern GP.

The upper source/drain contact aCA may extend in the first direction D1 and be connected to a through-via 650. A portion of the upper source/drain contact aCA may be inserted into the gate cutting pattern 600. For example, a portion of the upper source/drain contact aCA may overlap with a portion of the gate cutting pattern 600 along the third direction D3. For example, a portion of the upper source/drain contact aCA may be located on the gapfill insulating layer 620 through the insulating liner 610 of the gate cutting pattern 600. For example, the upper source/drain contact aCA may be in contact with the second via portion 652 of the through-via 650. Accordingly, the upper source/drain contact aCA may be connected to the lower source/drain contact bCA through a through-via 650.

In some implementations, the upper source/drain contact aCA includes a conductive pattern and a barrier pattern surrounding the conductive pattern. For example, the conductive pattern may include aluminum, copper, tungsten, molybdenum, or a combination thereof. The barrier pattern may cover the sides and bottom surface of the conductive pattern. The barrier pattern may include a metal film or a metal nitride film. The metal film may include titanium, tantalum, tungsten, nickel, cobalt, platinum, or combinations thereof. The metal nitride film may include titanium nitride (TiN), tantalum nitride (TaN), tungsten nitride (WN), nickel nitride (NiN), cobalt nitride (CoN), platinum nitride (PtN), or a combination thereof.

In some implementations, the upper interlayer insulating layer is located on and covers the upper source/drain contact aCA.

The lower source/drain contact bCA may be located under the lower source/drain pattern LSD1 and may be electrically connected to the lower source/drain pattern LSD1. For example, the lower source/drain contact bCA may be electrically connected to the lower source/drain pattern LSD1 by penetrating the active pattern AP.

The connecting portion CM can be located under the lower source/drain contact bCA and the through-via 650. The connecting portion CM may extend in the first direction D1 to connect the lower source/drain contact bCA and the through-via 650. Accordingly, the lower source/drain contact bCA may be connected to the upper source/drain contact aCA through the connecting portion CM and the through-via 650.

The connecting portion CM may be located between the lower wiring structure M1b and the lower source/drain contact bCA and the through-via 650 in the third direction D3. A portion of the connecting portion CM may be inserted into the gate cutting pattern 600. For example, a portion of the connecting portion CM may overlap with a portion of the gate cutting pattern 600 along the third direction D3. For example, a portion of the connecting portion CM may be located beneath the gapfill insulating layer 620 through the insulating liner 610 of the gate cutting pattern 600.

For example, the connecting portion CM may be in contact with the first via portion 651, the second via portion 652 of the through-via 650, or both.

Additionally, the lower gate contact bCB may be located under the lower gate pattern LGE1 and may be electrically connected to the lower gate pattern LGE1. For example, the bottom gate contact bCB may be electrically connected to the bottom gate pattern LGE1 by penetrating the active pattern AP or the device isolation layer ST.

In some implementations, each of the lower source/drain contact bCA and the lower gate contact bCB includes a conductive pattern and a barrier pattern surrounding the conductive pattern. For example, the conductive pattern may include a metal including aluminum, copper, tungsten, molybdenum, or combinations thereof. The barrier pattern may cover the sides and bottom surface of the conductive pattern. The barrier pattern may include a metal film or a metal nitride film. The metal film may include titanium, tantalum, tungsten, nickel, cobalt, platinum, or combinations thereof. The metal nitride film may include titanium nitride (TiN), tantalum nitride (TaN), tungsten nitride (WN), nickel nitride (NiN), cobalt nitride (CoN), platinum nitride (PtN), or a combination thereof.

A lower wiring structure M1b may be located beneath the lower source/drain contact bCA and the lower gate contact bCB.

The lower wiring structure M1b may include a lower interlayer insulating layer 410 and a lower metal layer 420 within the lower interlayer insulating layer 410.

The lower interlayer insulating layer may be located under the lower source/drain contact bCA and the lower gate contact bCB, and may cover the active pattern AP, the device isolation layer ST, the lower source/drain contact bCA, the lower gate contact bCB, the dummy source/drain pattern 155, the connecting portion CM, and the lower end of the separation pattern 520.

The lower interlayer insulating layer 410 may include an insulating material, for example, silicon oxide, silicon nitride, silicon oxynitride, a low-k material, or a combination thereof.

A lower metal layer 420 may be placed within the lower interlayer insulating layer 410. The lower metal layer 420 may include lower power wiring, lower wiring, and lower vias. The lower vias may be located on the lower power wiring and the lower wiring. The lower vias may be interposed between the lower source/drain contact bCA, the lower gate contact bCB, and the connecting portion CM and the lower power interconnections and lower interconnections, respectively.

The lower power wirings and the lower wirings of the lower metal layer 420 may include the same or different conductive materials. For example, the lower power wirings and lower wirings may include aluminum, copper, tungsten, molybdenum, cobalt, or combinations thereof.

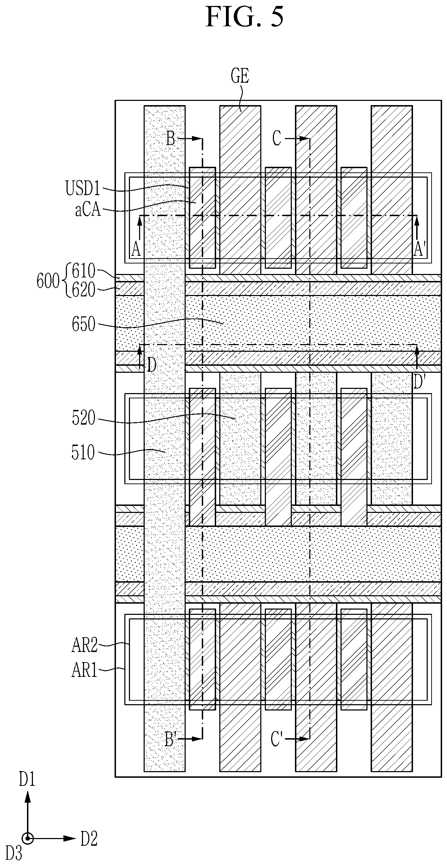

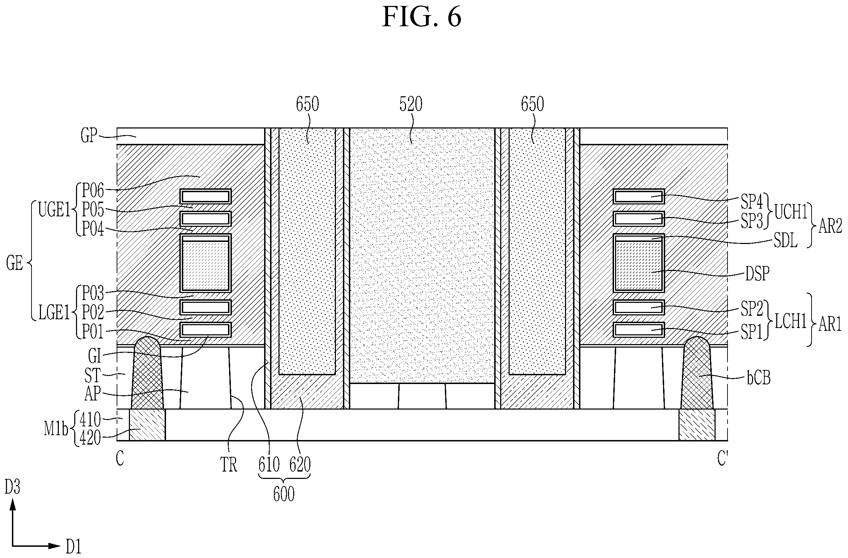

FIG. 5 is a plan view showing a semiconductor device according. FIG. 6 is a cross-sectional view taken along line C-C' of FIG. 5.

The example illustrated in FIGS. 5 and 6 is substantially the same as the example illustrated in FIGS. 1 to 4, and thus the description of FIGS. 1 to 4 applies equally to FIGS. 5 and 6 except where indicated otherwise or suggested otherwise by context. Additionally, the same reference numerals are used for the same components.

Referring to FIGS. 5 and 6, a portion of the separation pattern 520 need not be inserted into the gate cutting pattern 600. For example, the separation pattern 520 may not have a protrusion portion 522. The separation pattern 520 may not overlap with the gate cutting pattern 600 along the third direction D3. Additionally, the separation pattern 520 may be spaced apart from the through-via 650 in the first direction D1 and need not come into contact with the through-via 650.

Additionally, the lengths of the second via portion 652 and the third via portion 653 of the through-via 650 in the third direction D3 may be the same. For example, the second via portion 652 and the third via portion 653 may extend from the lower end to the upper end of the through-via 650 in the third direction D3. For example, the level of the lower end of the third via portion 653 in the third direction D3 may be substantially the same as the levels of the lower ends of the first via portion 651 and the second via portion 652. The level of the upper end of the third via portion 653 in the third direction D3 may be substantially the same as the levels of the upper ends of the first via portion 651 and the second via portion 652.

Accordingly, when removing the substrate 100 to form a lower source/drain contact bCA, the substrate 100 can be sufficiently removed until the dummy source/drain pattern 155 is exposed, while the through-via 650 can be formed so that the boundary between the through-via 650 and the gapfill insulating layer 620 when viewed in cross-section does not have an uneven wave shape in the third direction D3 while going along the second direction D2. In this case, the dispersion of the through-via 650 may be reduced to enable smoother contact between the through-via 650 and the lower source/drain contact bCA during the back wiring process.

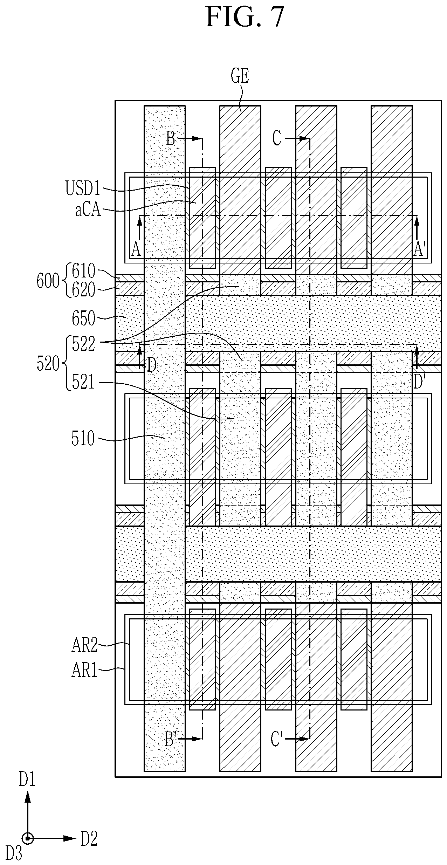

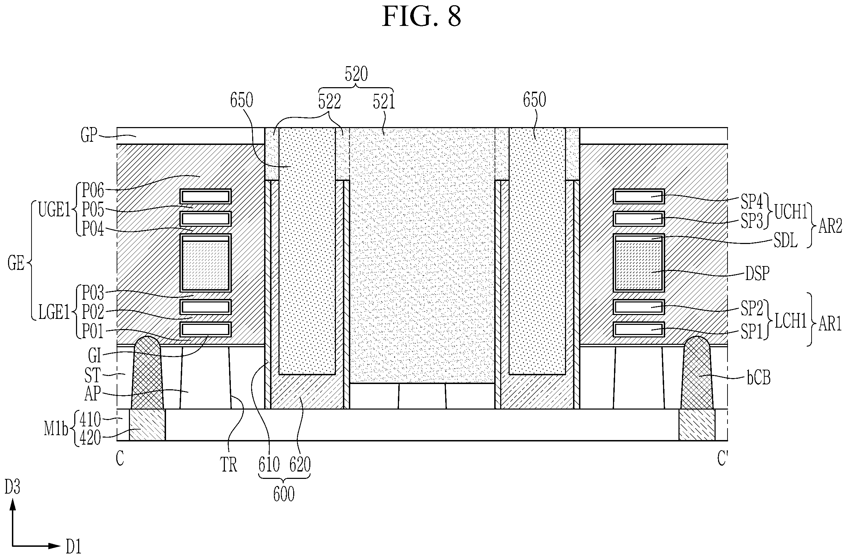

FIG. 7 is a plan view showing a semiconductor device. FIG. 8 is a cross-sectional view taken along line C-C' of FIG. 7. The example illustrated in FIGS. 7 and 8 is substantially the same as the example illustrated in FIGS. 1 to 4, and thus the description of FIGS. 1 to 4 applies equally to FIGS. 7 and 8 except where indicated otherwise or suggested otherwise by context. Additionally, the same reference numerals are used for the same components.

Referring to FIGS. 7 and 8, the separation pattern 520 may have a body portion 521 located next to the gate cutting pattern 600 in the first direction D1, and a protrusion portion 522 protruding from the body portion 521 in the first direction D1 and inserted (protruding) into the gate cutting pattern 600.

At this time, the protrusion portion 522 of the separation pattern 520 can be inserted into one side of the gate cutting pattern 600 in the first direction D1 and extended to the other side of the gate cutting pattern 600. Additionally, the through-via 650 may extend in the second direction D2 to separate the protrusion portion 522 located on one side of the gate cutting pattern 600 from the protrusion portion 522 located on the other side of the gate cutting pattern. For example, the through-via 650 may penetrate the protrusion portion 522 of the separation pattern 520 in the second direction D2.

Meanwhile, the lengths of the second via portion 652 and the third via portion 653 of the through-via 650 in the third direction D3 may be the same. For example, the second via portion 652 and the third via portion 653 may extend from the lower end to the upper end of the through-via 650 in the third direction D3. In other words, the level of the lower end of the third via portion 653 in the third direction D3 may be substantially the same as the levels of the lower ends of the first via portion 651 and the second via portion 652. The level of the upper end of the third via portion 653 in the third direction D3 may be substantially the same as the levels of the upper ends of the first via portion 651 and the second via portion 652.

Accordingly, when removing the substrate 100 to form a lower source/drain contact bCA, the substrate 100 may be sufficiently removed until the dummy source/drain pattern 155 is exposed, while the through-via 650 can be formed so that the boundary between the through-via 650 and the gapfill insulating layer 620 does not have an uneven wave shape in the third direction D3 along the second direction D2 when viewed in cross-section. In this case, the dispersion of the through-via 650 can be reduced to enable smoother contact between the through-via 650 and the lower source/drain contact bCA during the back wiring process.

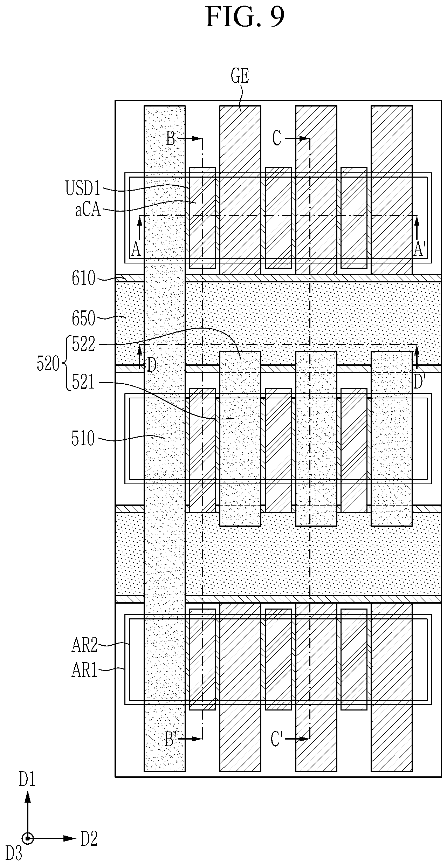

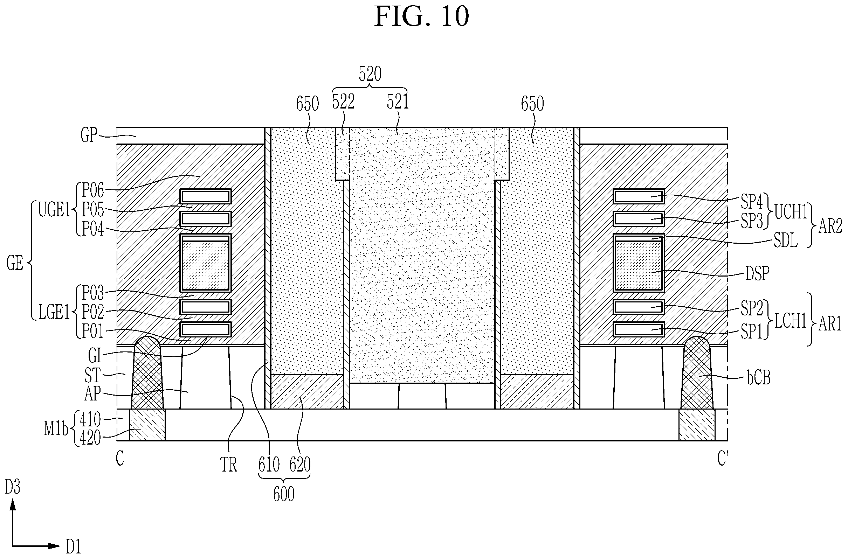

FIG. 9 is a plan view showing a semiconductor device. FIG. 10 is a cross-sectional view taken along line C-C' of FIG. 9. The example illustrated in FIGS. 9 and 10 is substantially the same as the example illustrated in FIGS. 1 to 4, and thus the description of FIGS. 1 to 4 applies equally to FIGS. 9 and 10 except where indicated otherwise or suggested otherwise by context. Additionally, the same reference numerals are used for the same components.

Referring to FIGS. 9 and 10, the through-via 650 may contact the insulating liner 610 in the first direction D1, and the gapfill insulating layer 620 may be located under the through-via 650 in the third direction D3.

For example, the gapfill insulating layer 620 is not located on either side of the through-via 650 in the first direction D1, and the through-via 650 can fill the inside of the gate cutting pattern 600 excluding the insulating liner 610 in the first direction D1. In other words, an insulating liner 610 may be located between the through-via 650 and the separation pattern 520, and a gapfill insulating layer 620 may not be located. Additionally, an insulating liner 610 may be located between the through-via 650 and the gate pattern GE, and a gapfill insulating layer 620 may not be located.

The protrusion portion 522 of the separation pattern 520 may be inserted into the gate cutting pattern 600 and may be overlapped with a portion of the gate cutting pattern 600 in the third direction D3, but the protrusion portion 522 may pass through the insulating liner 610 of the gate cutting pattern 600 and be located on the through-via 650 and need not be in contact with the gapfill insulating layer 620.

Meanwhile, the lengths of the second via portion 652 and the third via portion 653 of the through-via 650 in the third direction D3 may be the same. For example, the second via portion 652 and the third via portion 653 may extend from the lower end to the upper end of the through-via 650 in the third direction D3. In other words, the level of the lower end of the third via portion 653 in the third direction D3 may be substantially the same as the levels of the lower ends of the first via portion 651 and the second via portion 652. The level of the upper end of the third via portion 653 in the third direction D3 may be substantially the same as the levels of the upper ends of the first via portion 651 and the second via portion 652.

Accordingly, when removing the substrate 100 to form a lower source/drain contact bCA, the substrate 100 can be sufficiently removed until the dummy source/drain pattern 155 is exposed, while the through-via 650 may be formed so that the boundary between the through-via 650 and the gapfill insulating layer 620 does not have an uneven wave shape in the third direction D3 along the second direction D2 when viewed in cross-section. In this case, the dispersion of the through-via 650 may be reduced to enable smoother contact between the through-via 650 and the lower source/drain contact bCA during the back wiring process.

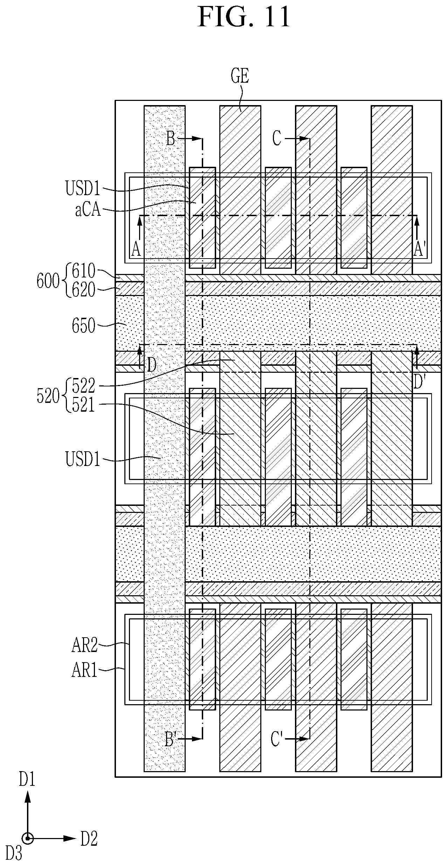

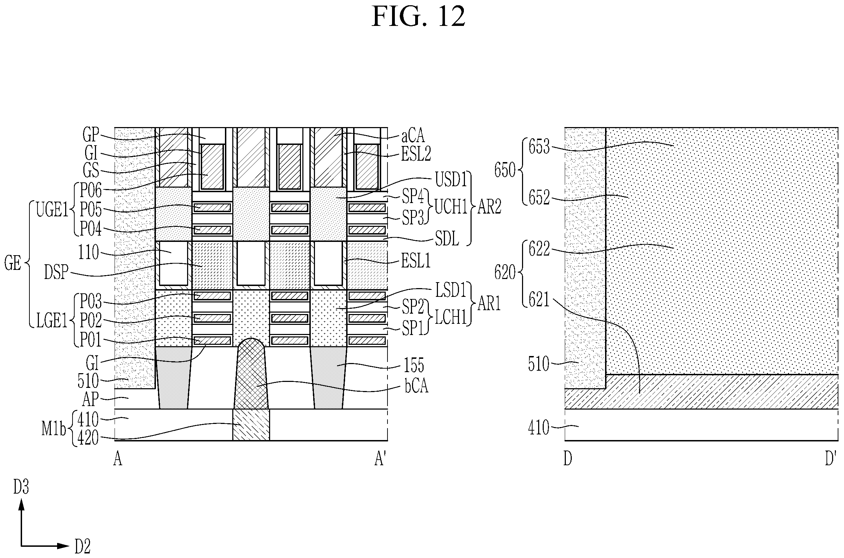

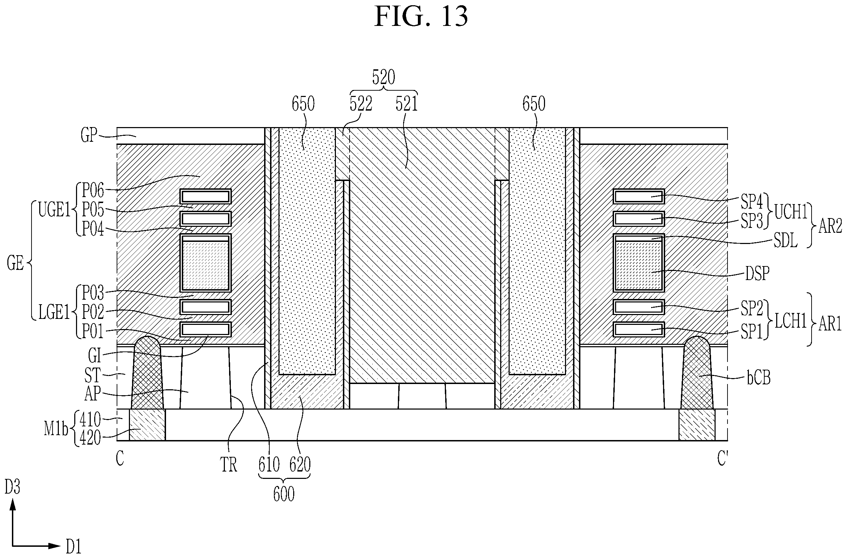

FIG. 11 is a plan view showing an example of a semiconductor device. FIG. 12 is a cross-sectional view taken along lines A-A' and D-D' of FIG. 11. FIG. 13 is a cross-sectional view taken along line C-C' of FIG. 11. The example illustrated in FIGS. 11 to 13 is substantially the same as the example illustrated in FIGS. 1 to 4, and thus the description of FIGS. 1 to 4 applies equally to FIGS. 11 to 13 except where indicated otherwise or suggested otherwise by context . Additionally, the same reference numerals are used for the same components.

Referring to FIGS. 11 to 13, the gate cutting pattern 600 includes a gapfill insulating layer 620 including silicon oxide and an insulating liner 610 including silicon nitride, and the separation pattern 520 may include silicon oxide.

In this case, when etching the gate cutting pattern 600 to form the through-via 650, even if the protrusion portion 522 of the separation pattern 520 is etched together, since the etching rates of the gapfill insulating layer 620 of the gate cutting pattern 600 and the separation pattern 520 are similar, the etching is performed uniformly, and thus the through-via 650 may be formed so that the boundary between the through-via 650 and the gapfill insulating layer 620 does not have an uneven wave shape in the third direction D3 along the second direction D2 when viewed in cross-section (for example, FIG. 12). In this case, the dispersion of the through-via 650 may be reduced to enable smoother contact between the through-via 650 and the lower source/drain contact bCA during the back wiring process.

A portion of the separation pattern 520 may extend in the first direction D1 and inserted (protrude) into the gate cutting pattern 600. For example, the separation pattern 520 may have a body portion 521 and a protrusion portion 522, and the protrusion portion 522 of the separation pattern 520 may be inserted into the gate cutting pattern 600.

The lengths of the second via portion 652 and the third via portion 653 of the through-via 650 in the third direction D3 may be the same. For example, the second via portion 652 and the third via portion 653 may extend from the lower end to the upper end of the through-via 650 in the third direction D3. In other words, the level of the lower end of the third via portion 653 in the third direction D3 may be substantially the same as the levels of the lower ends of the first via portion 651 and the second via portion 652. The level of the upper end of the third via portion 653 in the third direction D3 may be substantially the same as the levels of the upper ends of the first via portion 651 and the second via portion 652.

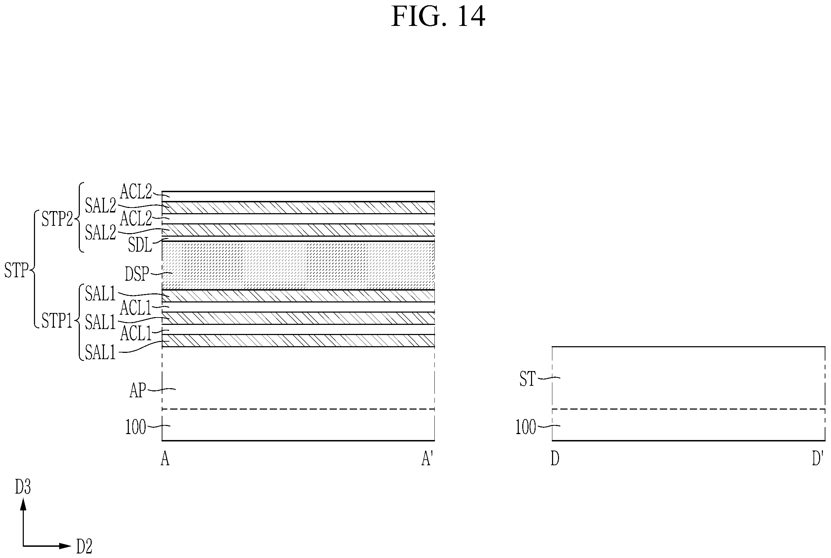

Next, a method for manufacturing a semiconductor device will be described with reference to FIGS. 14 to 48. In addition, reference may be made to FIGS. 1 to 4 described above.

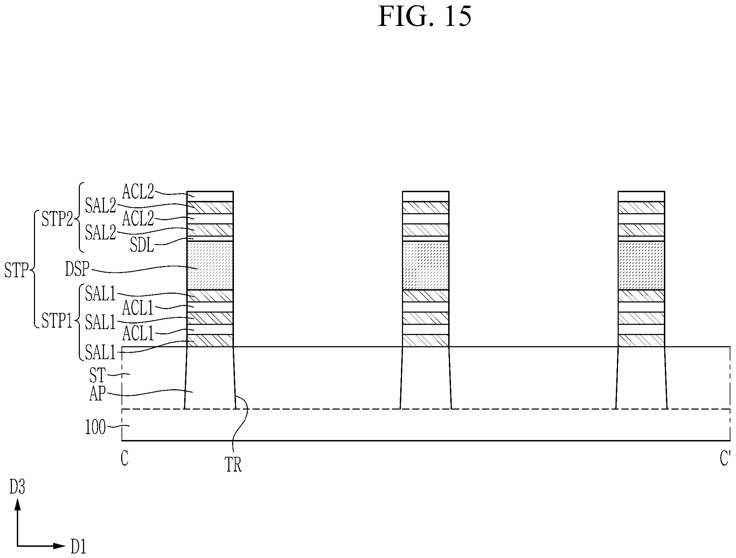

FIG. 14 is a cross-sectional view taken along lines A-A' and D-D' of FIG. 1. FIG. 15 is a cross-sectional view taken along line C-C' of FIG. 1. At this time, the cross-sectional view cut along the B-B' line of FIG. 1 may be the same as FIG. 15, and thus it is omitted.

Referring to FIGS. 14 and 15, first and second sacrificial layers SAL1 and SAL2 and first and second active layers ACL1 and ACL2 can be alternately laminated on a substrate 100.

For example, a first sacrificial layer SAL1, a first active layer ACL1, a first sacrificial layer SAL1, a first active layer ACL1, and a first sacrificial layer SAL1 may be sequentially stacked on a substrate 100. An intermediate insulating structure DSP and a dummy channel pattern SDL may be stacked on the first sacrificial layer SAL1. A second sacrificial layer SAL2, a second active layer ACL2, a second sacrificial layer SAL2, and a second active layer ACL2 may be sequentially stacked on a dummy channel pattern SDL.

The substrate 100 may be a semiconductor substrate including silicon, germanium, silicon germanium, etc., or a compound semiconductor substrate. As an example, the substrate 100 may be a silicon substrate.

The first and second sacrificial layers SAL1 and SAL2 may include another one of silicon (Si), germanium (Ge), or silicon germanium (SiGe). For example, the first to fourth active layers ACL1 to ACL4 may include silicon (Si).

The stacked first and second sacrificial layers SAL1 and SAL2, the first and second active layers ACL1 and ACL2, the intermediate insulating structure DSP, and the dummy channel pattern SDL can be patterned to form a stacked pattern STP.

For example, the stacked pattern STP can be formed by forming a hard mask pattern on the second active layer ACL2 at the top and etching the stacked layers on the substrate 100 using the hard mask pattern as an etching mask. While the stacked pattern STP is being formed, the upper end of the substrate 100 may be patterned to form a trench TR defining an active pattern AP. The stacked pattern STP may have a bar shape extending in the second direction D2.

The stacked pattern STP may include a lower stacked pattern STP1 over an active pattern AP, and an upper stacked pattern STP2 on the lower stacked pattern STP1. The lower stacked pattern STP1 may include alternately stacked first sacrificial layers SAL1 and first active layers ACL1. The upper stacked pattern STP2 may include alternately stacked second sacrificial layers SAL2 and second active layers ACL2.

On the substrate 100, a device isolation layer ST that fills the trench may be formed. For example, an insulating layer covering the active pattern AP and the stacked pattern STP may be formed over the entire surface of the substrate 100. The insulating layer may be recessed until the stacked pattern STP is exposed, thereby forming a device isolation layer ST.

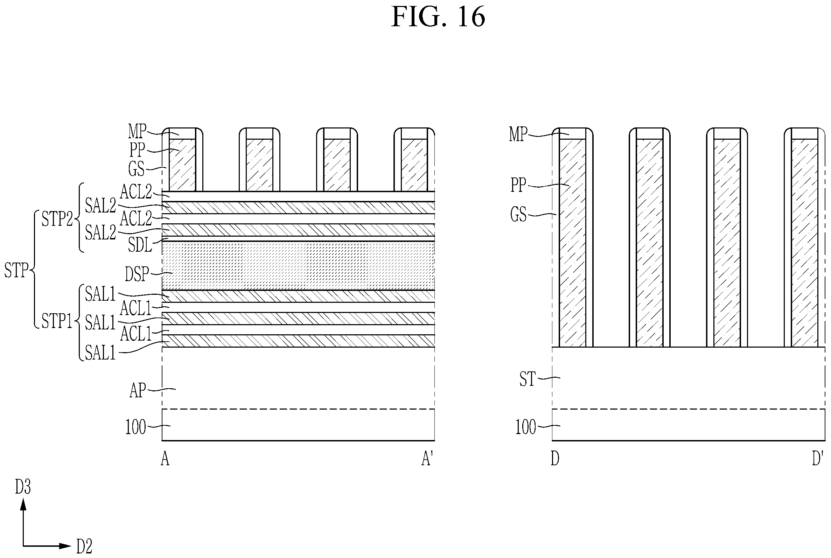

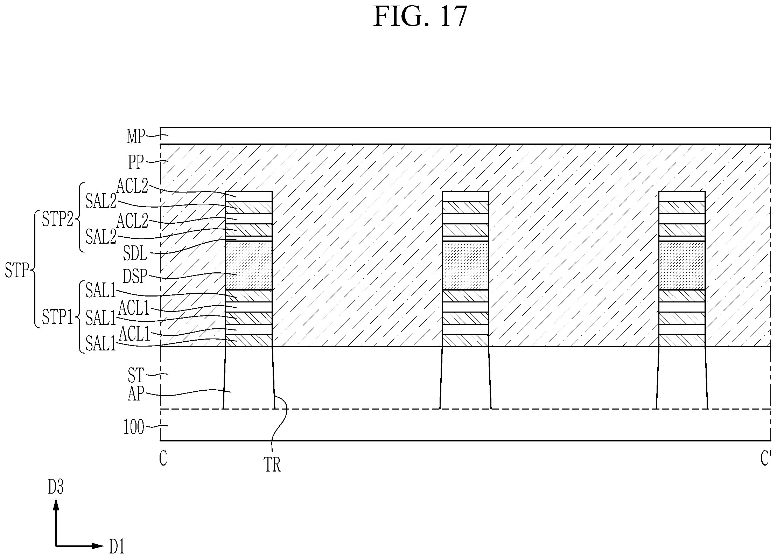

FIG. 16 is a cross-sectional view taken along lines A-A' and D-D' of FIG. 1. FIG. 17 is a cross-sectional view taken along line C-C' of FIG. 1. At this time, the cross-sectional view cut along the B-B' line of FIG. 1 may be the same as FIG. 17, and thus it is omitted.

Referring to FIGS. 16 and 17, a plurality of sacrificial patterns PP may be formed across the stacked pattern STP. Each sacrificial pattern PP may be formed in a line shape extending in the first direction D1. For example, the sacrificial pattern PP may be formed by forming a sacrificial film on a stacked pattern STP, forming a hard mask pattern on the sacrificial film, and patterning the sacrificial film using the hard mask pattern as an etching mask. The sacrificial film may include amorphous silicon or polysilicon.

Additionally, a preliminary capping layer MP and a pair of gate spacers GS may be formed on both side surfaces of the sacrificial pattern PP in the second direction D2, respectively.

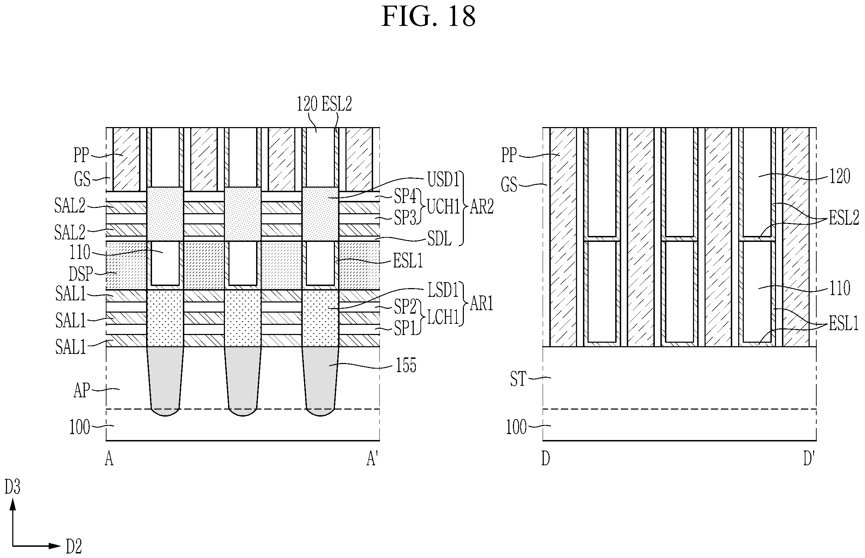

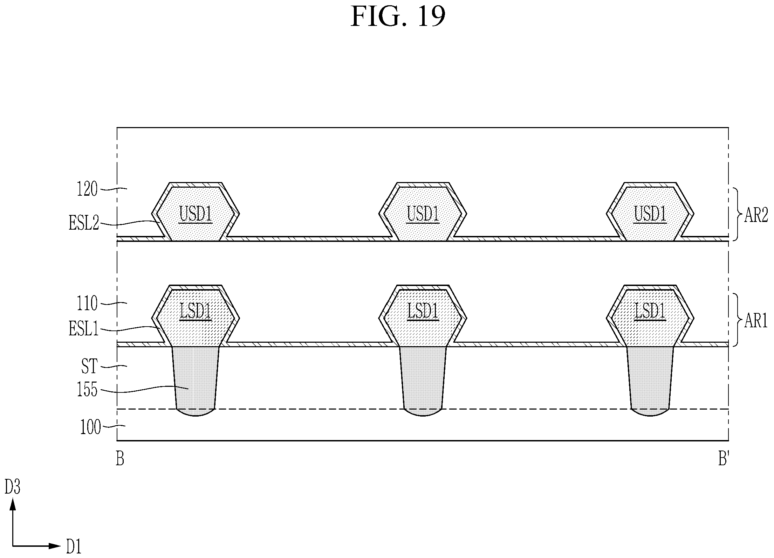

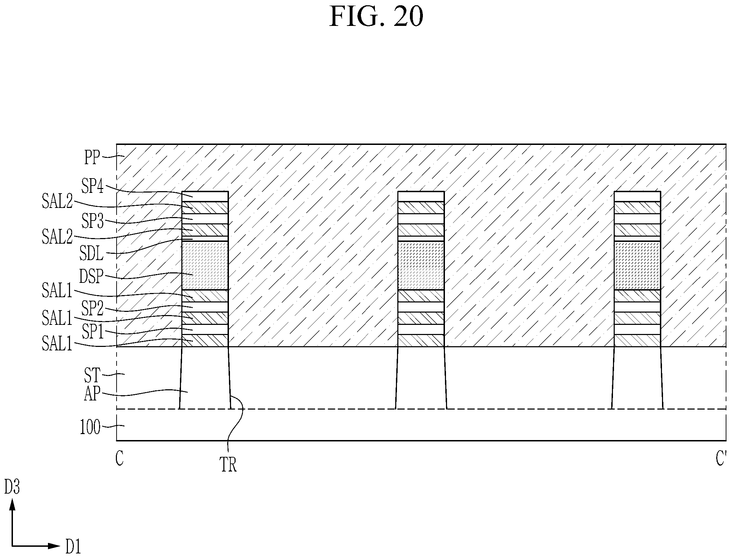

FIG. 18 is a cross-sectional view taken along lines A-A' and D-D' of FIG. 1. FIG. 19 is a cross-sectional view taken along line B-B' of FIG.1. FIG. 20 is a cross-sectional view taken along line C-C' of FIG. 1.

Referring to FIGS. 18 to 20, at least a portion of a stacked pattern STP and an active pattern AP are etched using the sacrificial patterns PP, the preliminary capping layer MP, and the gate spacers GS as etching masks to form recesses, and a dummy source/drain pattern 155, a lower source/drain pattern LSD1, a first interlayer stop film ESL1, a first interlayer insulating layer 110, an upper source/drain pattern USD1, a second interlayer stop film ESL2, and a second interlayer insulating layer 120 may be sequentially formed within the recesses.

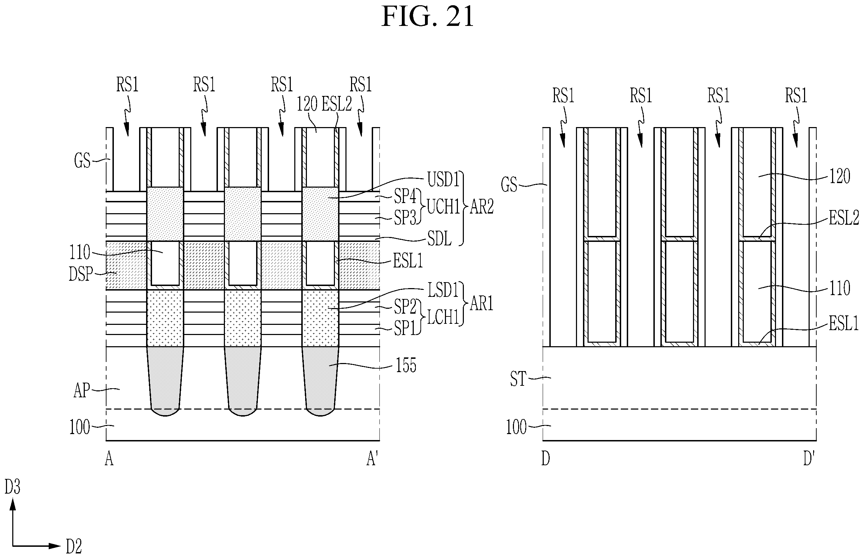

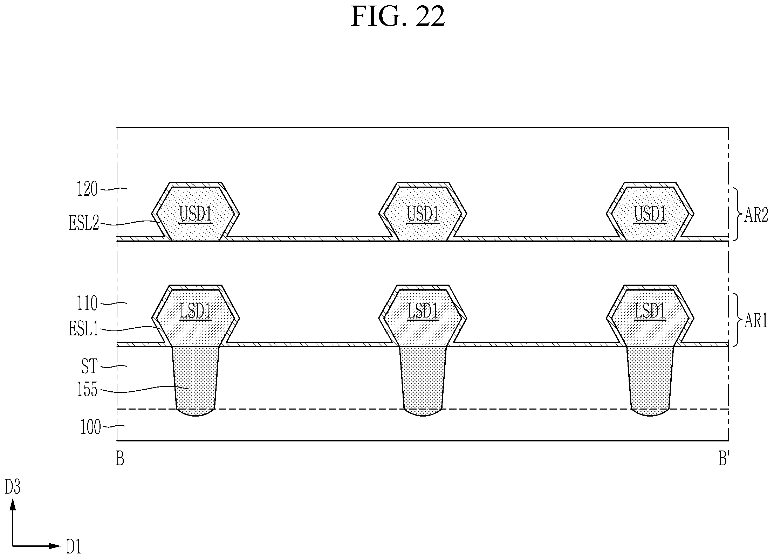

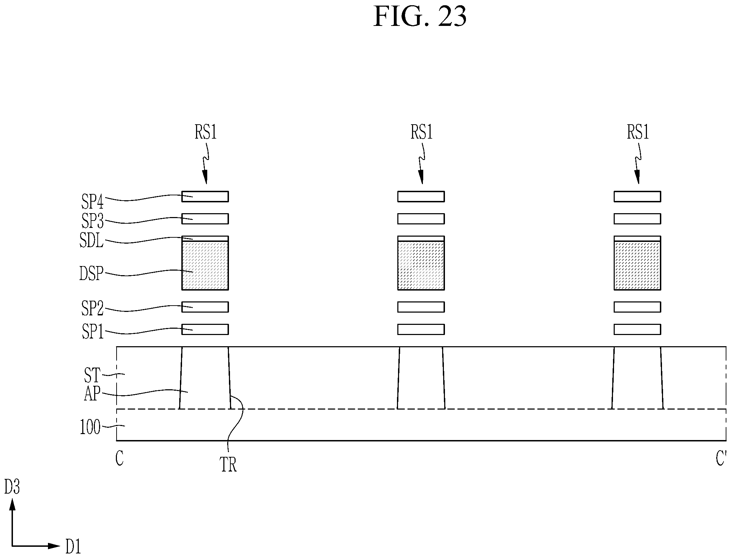

FIG. 21 is a cross-sectional view taken along lines A-A' and D-D' of FIG. 1. FIG. 22 is a cross-sectional view taken along line B-B' of FIG. 1. FIG. 23 is a cross-sectional view taken along line C-C' of FIG. 1.

Referring to FIGS. 21 to 23, the preliminary capping layer MP may be removed to expose the sacrificial pattern PP, and the first recesses ET2 may be formed by removing the exposed sacrificial pattern PP.

For example, to remove the sacrificial pattern PP, wet etching using an etchant that selectively etch polysilicon can be used. By removing the sacrificial pattern PP, the first and second sacrificial layers SAL1 and SAL2 may be exposed.

Next, an etching process is performed to selectively etch the exposed first and second sacrificial layers SAL1 and SAL2, so that only the first and second sacrificial layers SAL1 and SAL2 may be removed while leaving the first and second semiconductor patterns SP1 and SP2 intact.

For example, the etching process of the first and second sacrificial layers SAL1 and SAL2 can have a high etching rate for silicon germanium. For example, the etching process can have a high etching rate for silicon germanium having a germanium concentration greater than 10 at%.

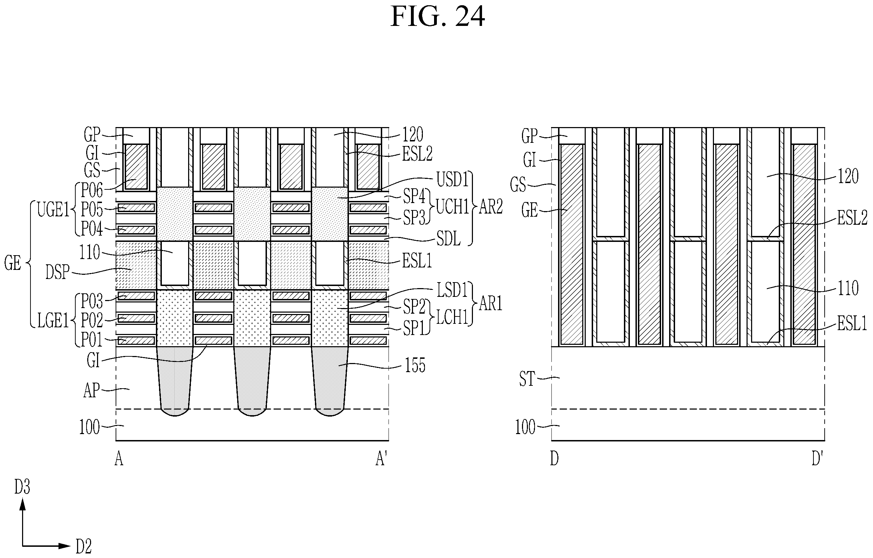

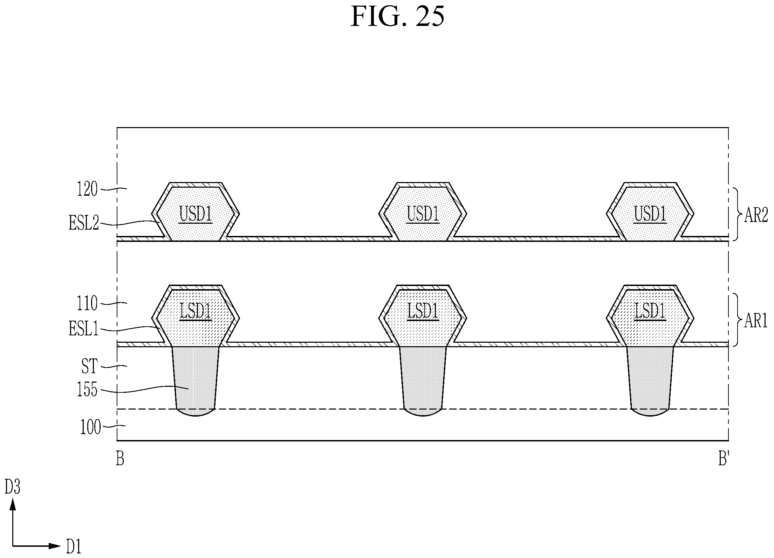

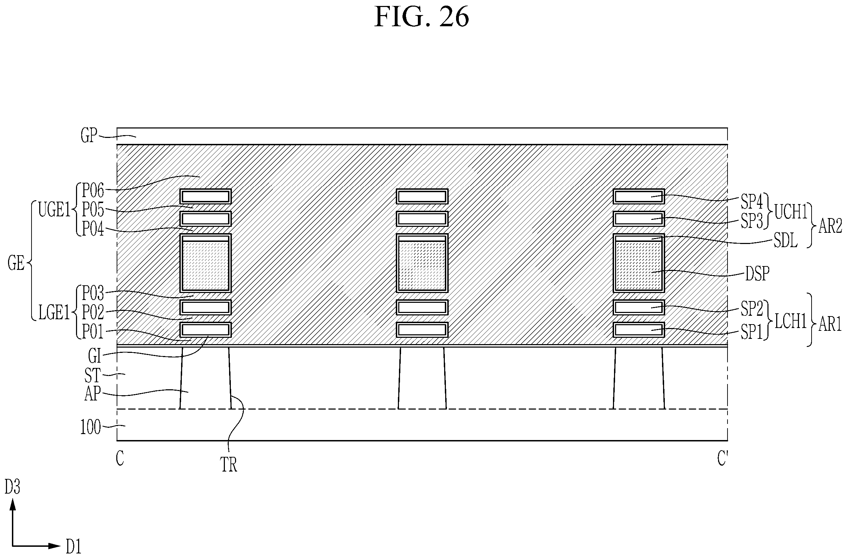

FIG. 24 is a cross-sectional view taken along lines A-A' and D-D' of FIG. 1. FIG. 25 is a cross-sectional view taken along line B-B' of FIG. 1. FIG. 26 is a cross-sectional view taken along line C-C' of FIG. 1.

Referring to FIGS. 24 to 26, a gate pattern GE may be formed within a region where the sacrificial pattern PP and the first and second sacrificial layers SAL1 and SAL2 are removed.

First, a gate insulating film GI may be conformally formed within the region where the sacrificial pattern PP and the first and second sacrificial layers SAL1 and SAL2 are removed.

Next, a gate pattern GE may be formed on the gate insulating film GI. The formation of the gate pattern GE may be performed by forming a lower gate pattern LGE1 including first to third sub-gate portions PO1 to PO3 between first semiconductor patterns SP1, and forming an upper gate pattem UGE1 including fourth to sixth sub-gate portions PO4 to PO6 between second semiconductor patterns (SP2).

The gate pattern GE may be recessed, reducing its height. The gate capping pattern GP may be formed on the recessed gate pattern GE. A planarization process may be performed on the gate capping pattern GP so that the upper surface of the gate capping pattern GP is coplanar with the upper surface of the second interlayer insulating layer 120.

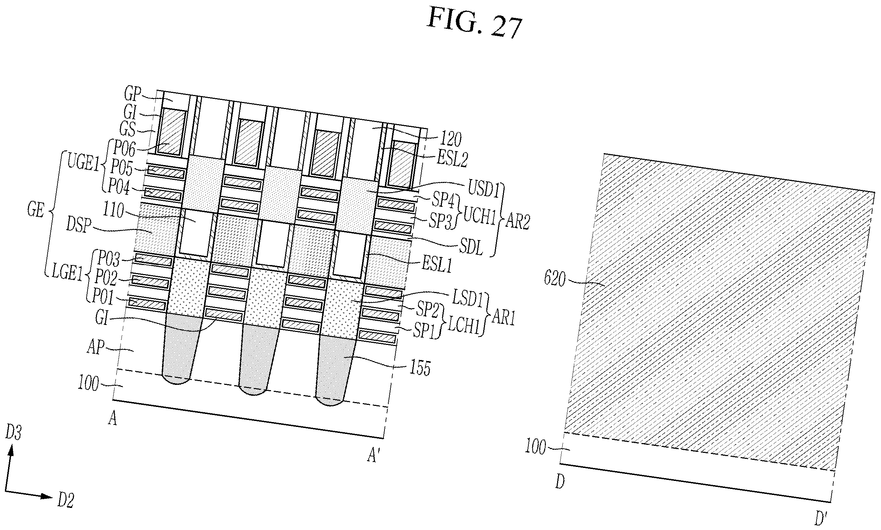

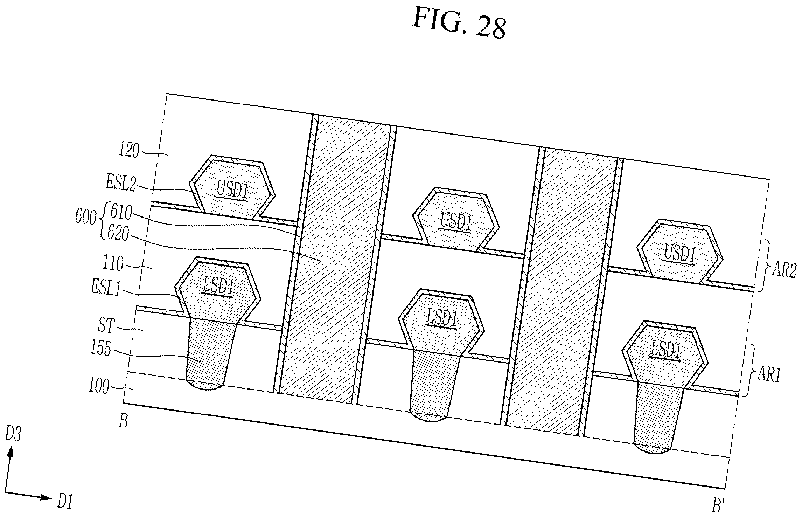

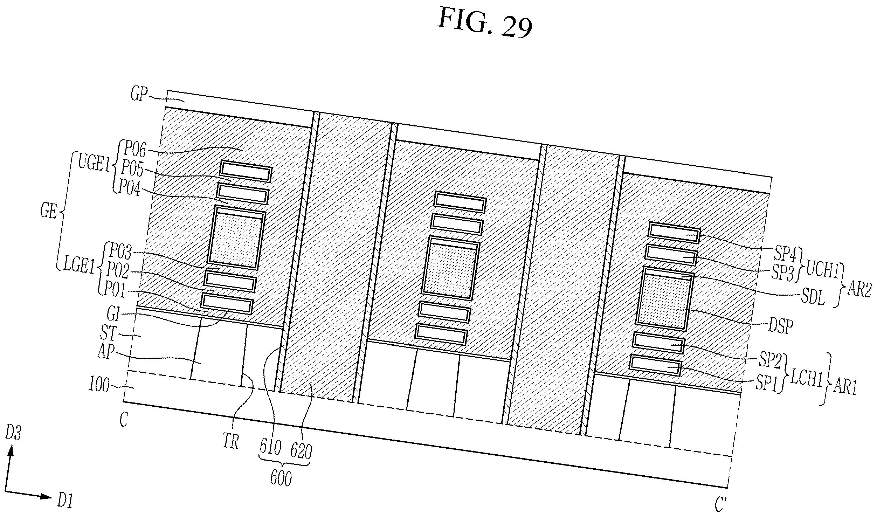

FIG. 27 is a cross-sectional view taken along lines A-A' and D-D' of FIG. 1. FIG. 28 is a cross-sectional view taken along line B-B' of FIG. 1. FIG. 29 is a cross-sectional view taken along line C-C' of FIG. 1.

Referring to FIGS. 27 to 29, a gate cutting pattern 600 that extends across the gate pattern GE in the second direction D2 to cut the connection of the gate pattern GE may be formed.

For example, the gate cutting pattern 600 may be formed by forming a hard mask pattern on a gate capping pattern GP, etching a gate pattern GE using the hard mask pattern as an etching mask, conformally applying an insulating liner 610 to a region where the gate pattern GE has been removed, and then filling a space between the insulating liners 610 with a gapfill insulating layer 620.

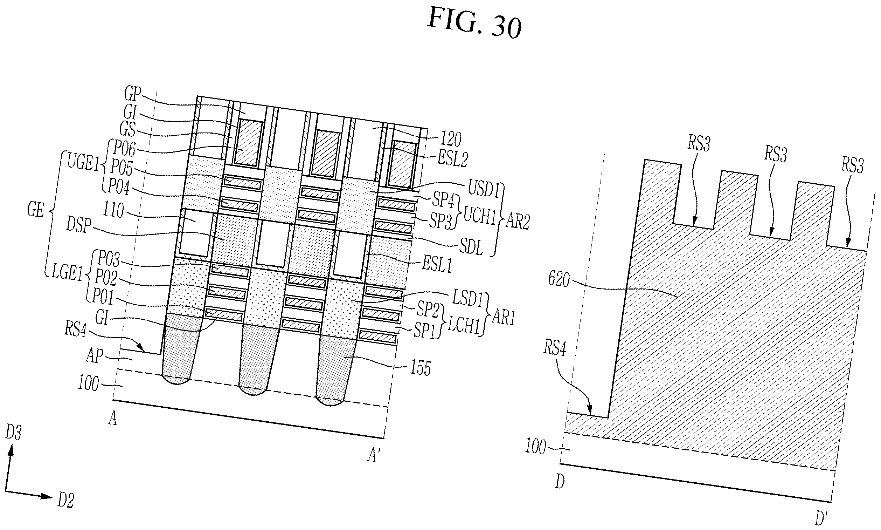

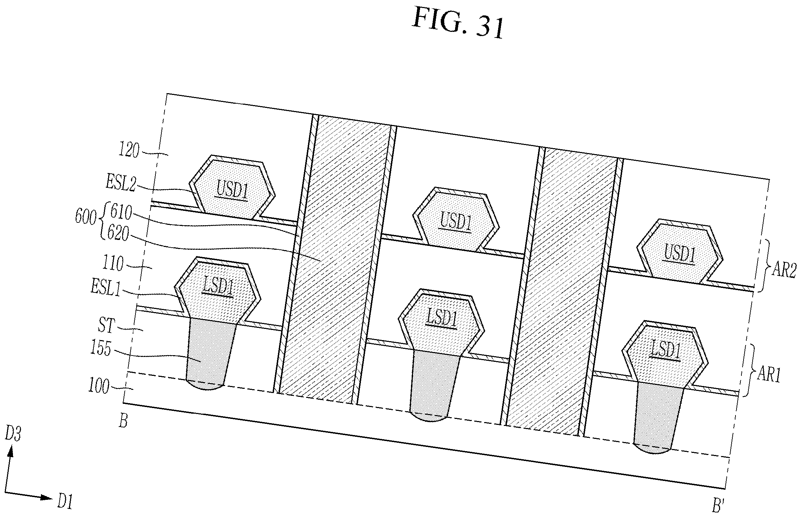

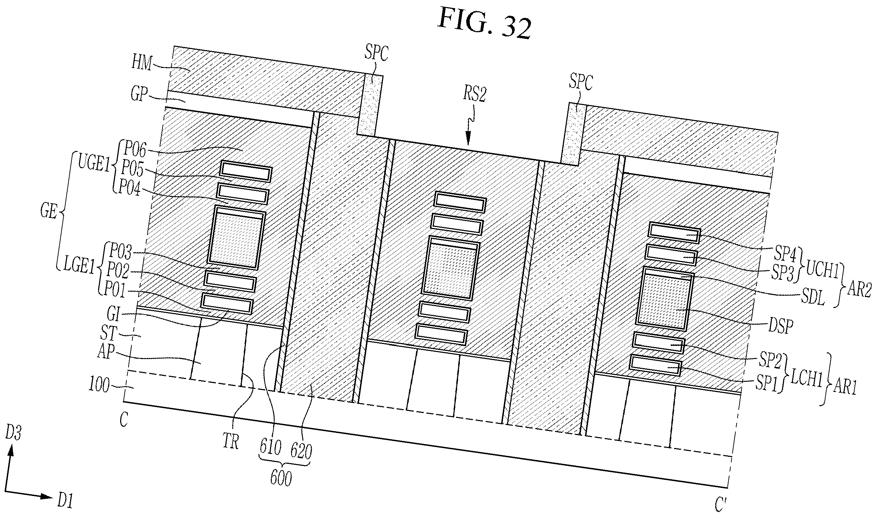

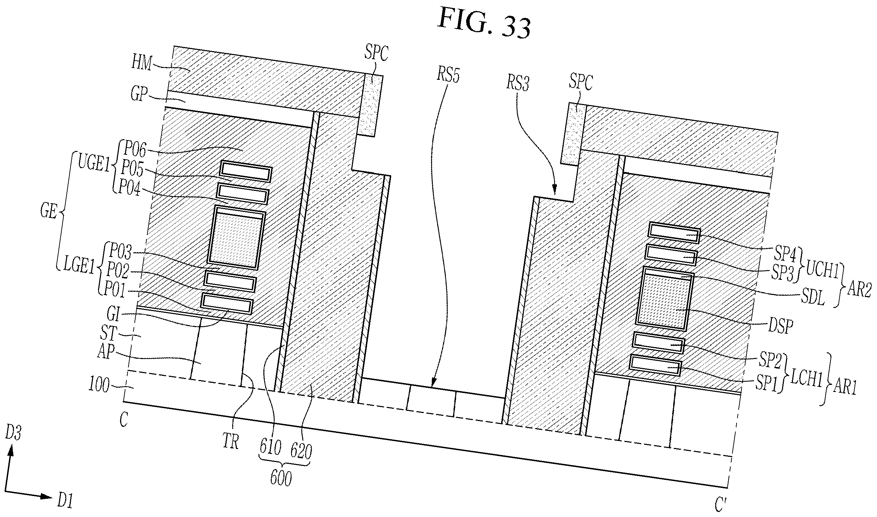

FIG. 30 is a cross-sectional view taken along lines A-A' and D-D' of FIG. 1. FIG. 31 is a cross-sectional view taken along line B-B' of FIG. 1. FIGS. 32 and 33 are cross-sectional views taken along line C-C' of FIG. 1.

Referring to FIGS. 30 to 33, a fourth recess RS4 is formed at a location where a separation structure 510 is to be formed, and a fifth recess RS5 is formed at a location where a separation pattern 520 is to be formed.

For example, a hard mask pattern HM is formed on a gate capping pattern GP, and the gate capping pattern GP is etched using the hard mask pattern HM as an etching mask to form a second recess RS2 to expose the gate pattern GE. At this time, spacers SPC may be formed on both side walls of the first direction D1 of the second recess RS2.

Next, the gate pattern GE exposed by the second recess RS2 is removed, and the upper channel pattern UCH1 and the lower channel pattern LCH1 exposed as the gate pattern GE is removed are removed. In this process, other gate patterns GE located under the hard mask pattern HM may not be removed by the spacer SPC, a gapfill insulating layer 620 of a gate cutting pattern 600 located under the spacer SPC may be partially etched to form a third recess RS3, and a portion of an active pattern AP and a device isolation layer ST located under a lower channel pattern LCH1 may be removed to form a fifth recess RS5.

However, at this time, the active pattern AP and the device isolation layer ST within the fifth recess RS5 are not completely removed, and at least a portion of the active pattern AP and the device isolation layer ST remain. Accordingly, the level of the lower end of the separation pattern 520 formed in the fifth recess RS5 thereafter may be higher than the level of the lower end of the dummy source/drain pattern 155, and when the substrate 100 is removed to form a lower source/drain contact bCA, the substrate 100 is prevented from being insufficiently removed due to being stopped by the separation pattern 520, and the substrate 100 can be sufficiently removed until the dummy source/drain pattern 155 is revealed.

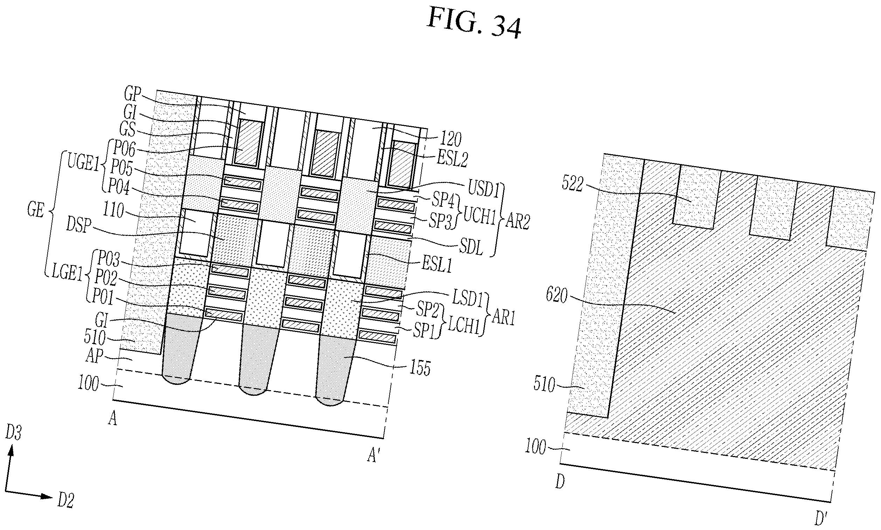

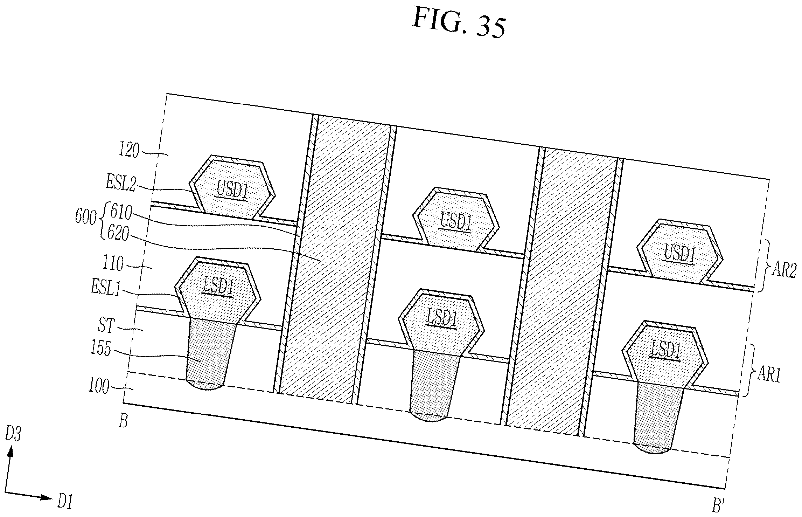

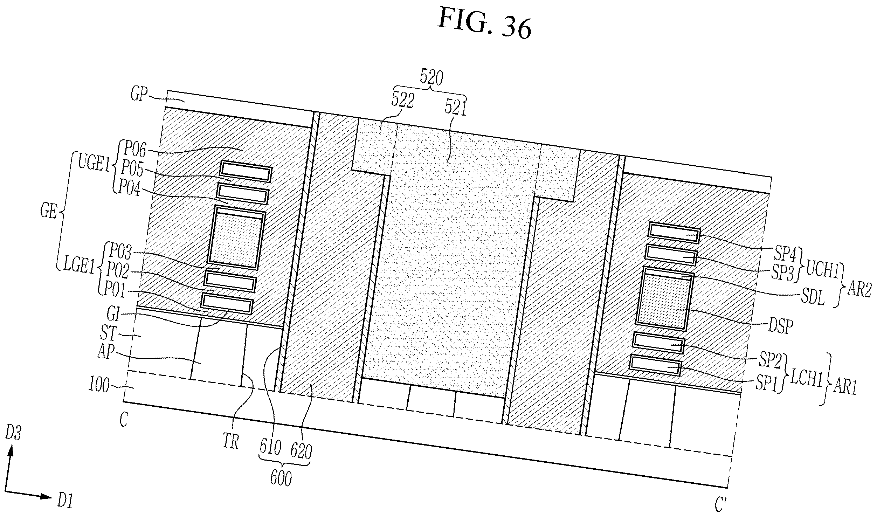

FIG. 34 is a cross-sectional view taken along lines A-A' and D-D' of FIG. 1. FIG. 35 is a cross-sectional view taken along line B-B' of FIG. 1. FIG. 36 is a cross-sectional view taken along line C-C' of FIG. 1.

Referring to FIGS. 34 to 36, a separation structure 510 is formed within the fourth recess RS4, and a separation pattern 520 is formed within the third recess RS3 and the fifth recess RS5.

For example, the separation structure 510 and the separation pattern 520 may be formed by filling an insulating material in each of the third recess RS3 to the fifth recess RS5 and flattening the insulating material until the hard mask pattern HM is exposed. Planarization of the insulating material may be performed using an etch back or chemical mechanical polishing (CMP) process.

At this time, a body portion 521 of a separation pattern 520 can be formed within the fifth recess RS5, and a protrusion portion 522 of a separation pattern 520 may be formed within the third recess RS3. The protrusion portion 522 of the separation pattern 520 may be located on the gapfill insulating layer 620. If the materials of the separation pattern 520 and the spacer SPC are the same, the boundary between the separation pattern 520 and the spacer SPC may not be recognized. Afterwards, the spacer SPC and hard mask pattern HM may be removed.

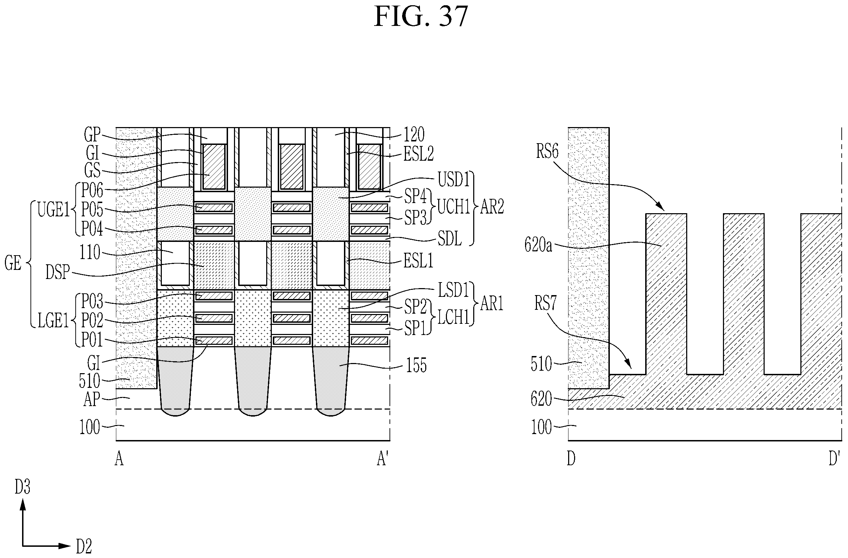

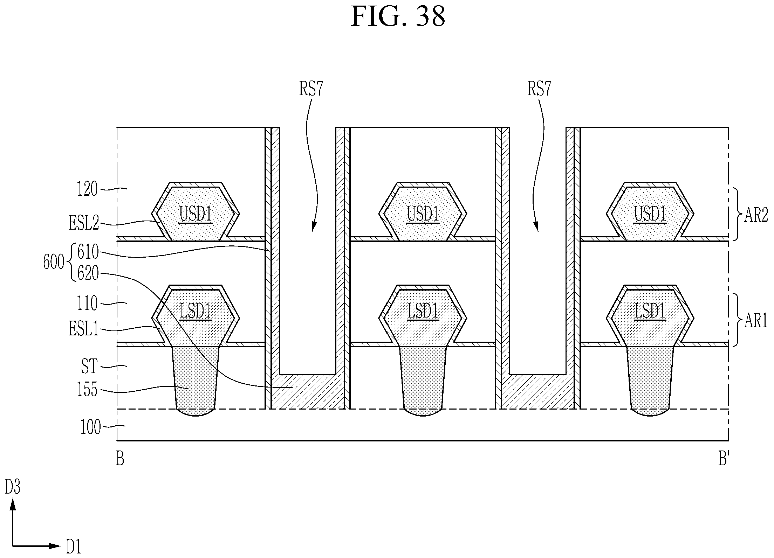

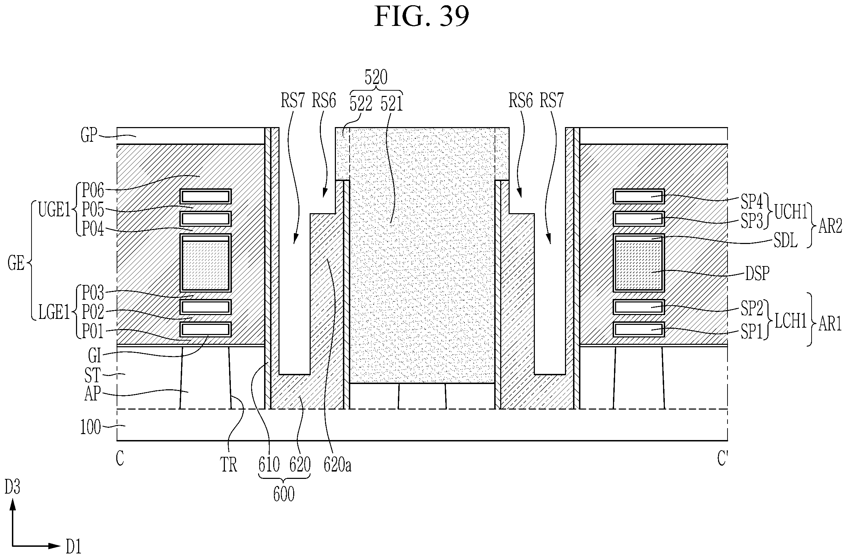

FIG. 37 is a cross-sectional view taken along lines A-A' and D-D' of FIG. 1. FIG. 38 is a cross-sectional view taken along line B-B' of FIG. 1. FIG. 39 is a cross-sectional view taken along line C-C' of FIG. 1.

Referring to FIGS. 37 to 39, the gapfill insulating layer 620 of the gate cutting pattern 600 is etched at a location where a through-via 650 is to be formed to form a sixth recess RS6 and a seventh recess RS7.

For example, a hard mask pattern is formed on a gate capping pattern GP, and a gapfill insulating layer 620 of a gate cutting pattern 600 is etched using the hard mask pattern as an etching mask.

At this time, when etching the gapfill insulating layer 620, at a location where the protrusion portion 522 of the separation pattern 520 is not inserted, the etching is relatively more, so that a seventh recess RS7 having a relatively deep depth in the third direction D3 is formed, and at a location where the protrusion portion 522 of the separation pattern 520 is inserted, since a portion of the protrusion portion 522 must be etched together with the gapfill insulating layer 620, the etching is relatively less, so that a sixth recess RS6 having a relatively shallow depth in the third direction D3 may be formed. An insertion portion 620a may be formed in the gapfill insulating layer 620 under the sixth recess RS6.

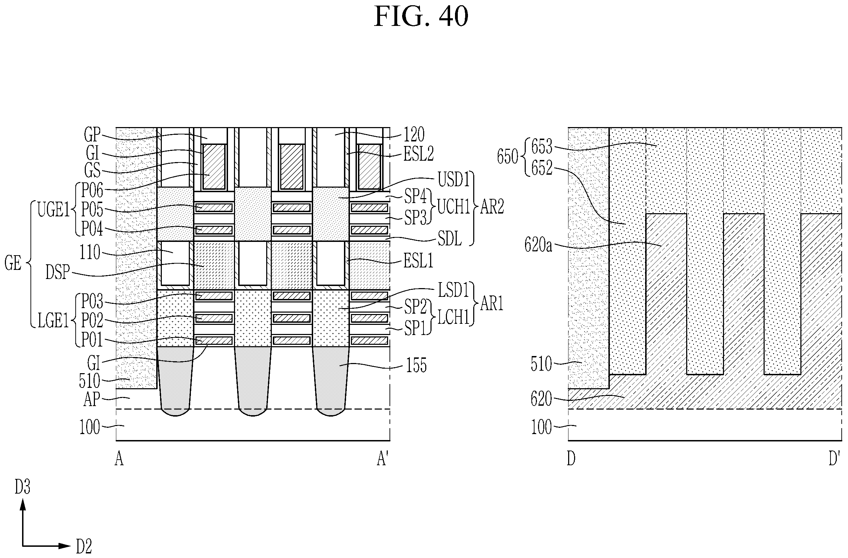

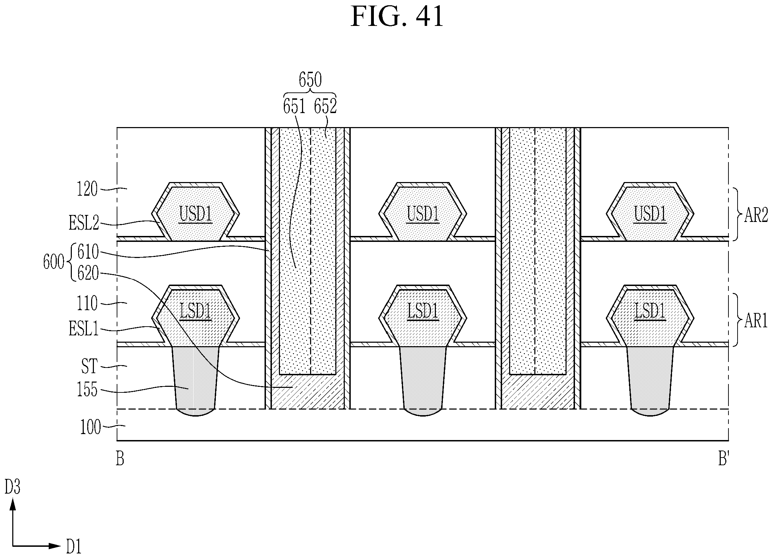

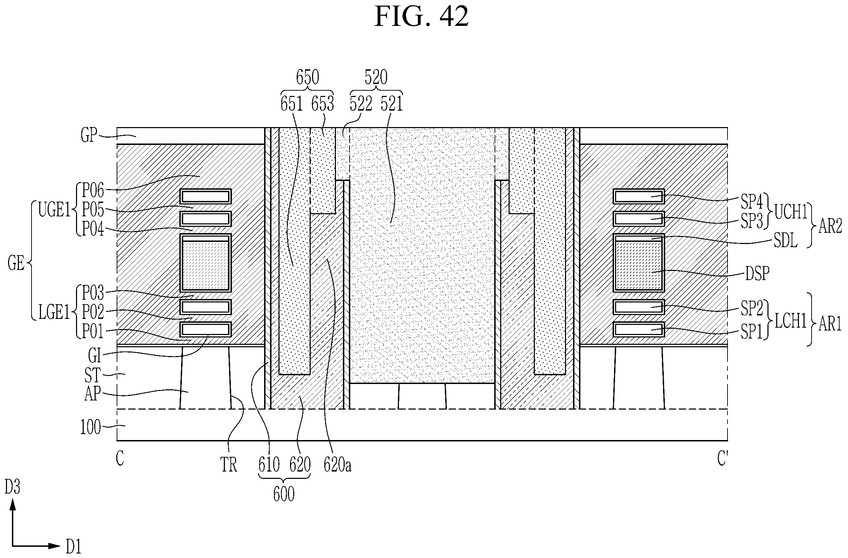

FIG. 40 is a cross-sectional view taken along lines A-A' and D-D' of FIG. 1. FIG. 41 is a cross-sectional view taken along line B-B' of FIG. 1. FIG. 42 is a cross-sectional view taken along line C-C' of FIG. 1.

Referring to FIGS. 40 to 42, a through-via 650 is formed in the sixth recess RS6 and the seventh recess RS7.

For example, the through-via 650 may be formed by filling metal in each of the sixth recess RS6 and the seventh recess RS7. At this time, a first via portion 651 and a second via portion 652 of a through-via 650 are formed within the seventh recess RS7, and a third via portion 653 is formed within the sixth recess RS6.

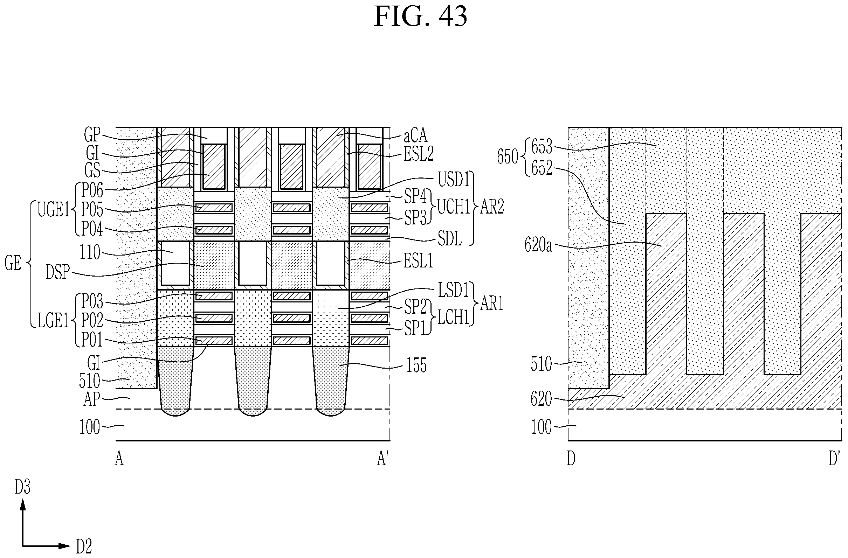

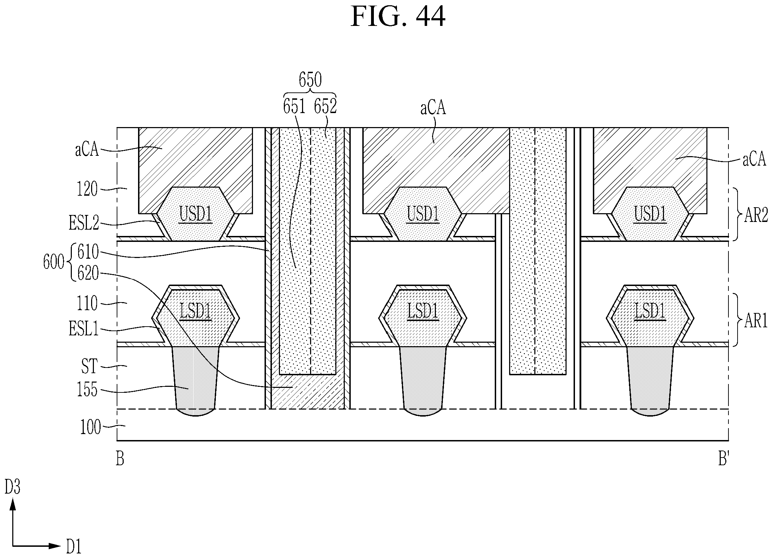

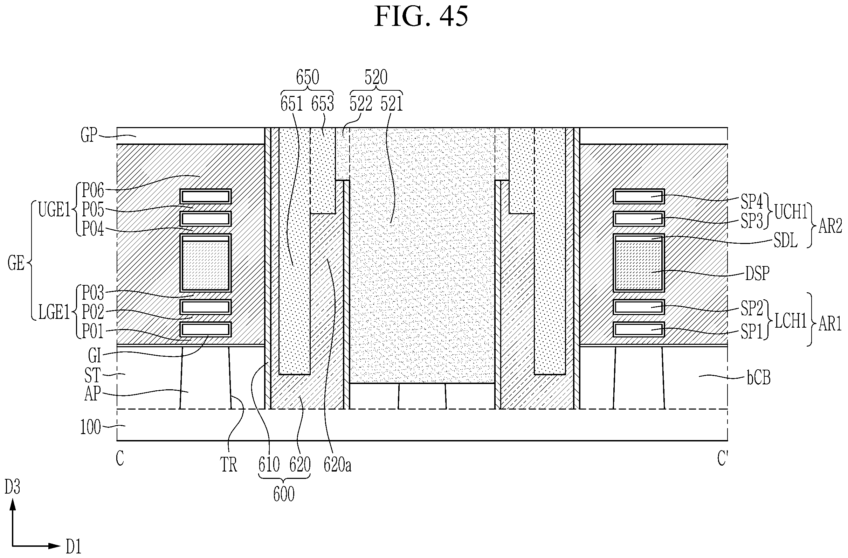

FIG. 43 is a cross-sectional view taken along lines A-A' and D-D' of FIG. 1. FIG. 44 is a cross-sectional view taken along line B-B' of FIG. 1. FIG. 45 is a cross-sectional view taken along line C-C' of FIG. 1.

Referring to FIGS. 43 to 45, an upper source/drain contact aCA is formed to connect to the upper source/drain pattern USD1.

For example, a hard mask pattern is formed on a second interlayer insulating layer 120, and the second interlayer insulating layer 120 is patterned using the hard mask pattern as an etching mask, so that the second interlayer insulating layer 120 penetrates in a third direction D3 to form a contact hole at the upper end of the upper source/drain pattern USD1. For example, the patterning may utilize dry etching.

By filling the contact hole with metal, an upper source/drain contact aCA may be formed that connects to the upper source/drain pattern USD1.

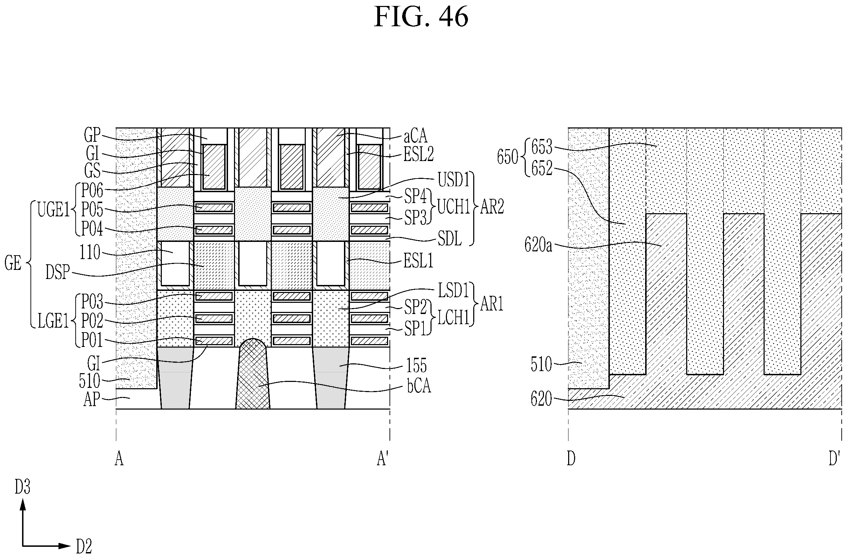

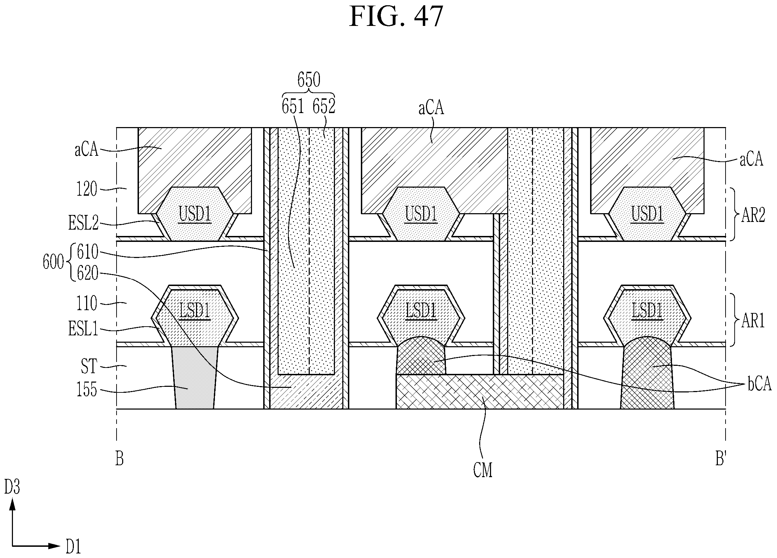

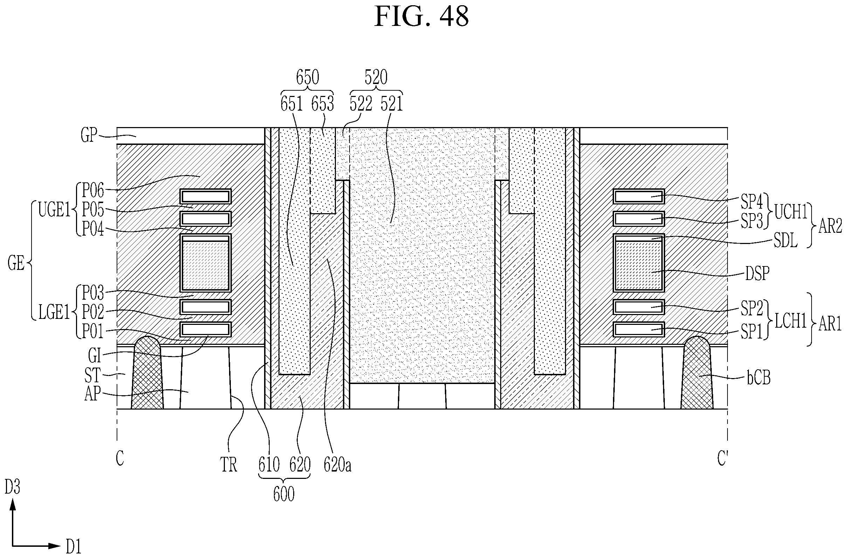

FIG. 46 is a cross-sectional view taken along lines A-A' and D-D' of FIG. 1. FIG. 47 is a cross-sectional view taken along line B-B' of FIG. 1. FIG. 48 is a cross-sectional view taken along line C-C' of FIG. 1.

Referring to FIGS. 46 to 48, first, the substrate 100 is removed.

For example, the substrate 100 may be removed by performing an etching process. The etching process may be performed by, for example, a wet etching method, but is not limited thereto.

At this time, since the level of the lower end of the separation pattern 520 in the third direction D3 is higher than the level of the lower end of the dummy source/drain pattern 155, the substrate 100 is prevented from being insufficiently removed by being stopped by the separation pattern 520, and the substrate 100 can be sufficiently removed until the dummy source/drain pattern 155 is revealed.

In some implementations, when the active pattern AP includes a semiconductor material such as silicon, the silicon may be removed and replaced with silicon oxide.

Next, a lower source/drain contact bCA connected to the lower source/drain pattern LSD1 is formed, and a lower gate contact bCB connected to the lower gate pattern LGE1 of the gate pattern GE is formed.

For example, a portion of the dummy source/drain pattern 155 may be removed to form a contact hole through which the lower source/drain pattern LSD1 is exposed. Next, a lower source/drain contact bCA is formed by filling the contact hole and electrically connecting to the lower source/drain pattern LSD1.

Next, a patterning process may be performed to remove a portion of the active pattern AP or the device isolation layer ST, thereby forming a contact hole through which the lower gate pattern LGE1 of the gate pattern GE is exposed. At this time, the contact hole may penetrate through the active pattern AP or the device isolation layer ST. Next, a lower gate contact bCB is formed that fills the contact hole and is electrically connected to the lower gate pattern LGE1 of the gate pattern GE.

Next, a connecting portion CM may be formed that extends from under the lower source/drain contact bCA to under the through-via 650. After the patterning process, the connecting portion CM may be filled with metal to form a connecting portion CM that connects the lower source/drain contact bCA and the through-via 650.

In the above, the case where the lower source/drain contact bCA, the lower gate contact bCB, and the connecting portion CM are formed in separate processes has been described, but the present disclosure is not limited thereto, and the lower source/drain contact bCA, the lower gate contact bCB, and the connecting portion CM may be formed simultaneously, or the lower gate contact bCB may be formed first, and then the lower source/drain contact bCA and the connecting portion CM may be formed.

Referring again to FIGS. 1 to 4, a lower wiring structure M1b including a lower metal layer 420 electrically connected to a lower source/drain contact bCA, a lower gate contact bCB, and a connecting portion CM at a lower end of a device isolation layer ST and an active pattern AP and a lower interlayer insulating layer 410 covering the lower metal layer 420 can be formed.

While this disclosure contains many specific implementation details, these should not be construed as limitations on the scope of what may be claimed. Certain features (e.g., floating pattern presence/configurations) that are described in this disclosure in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

While this disclosure has been described in connection with various examples, it is to be understood that the disclosure is not limited to those examples, but, on the contrary, is intended to cover various modifications and equivalent arrangements included within the scope of the disclosure.

## Claims

1. A semiconductor device, comprising:
an active pattern extending in a second direction different from a first direction, wherein the first direction and the second direction are in a common lateral plane;
a lower channel pattern and a lower source/drain pattern that are arranged on the active pattern and alternately arranged in the second direction;
an upper channel pattern on the lower channel pattern, and an upper source/drain pattern on the lower source/drain pattern;
a gate pattem extending in the first direction and arranged on the lower channel pattern and the upper channel pattern;
a separation pattern arranged, in the second direction, between (i) the lower source/drain pattern and the upper source/drain pattern and (ii) another lower source/drain pattern and another upper source/drain pattern; and
a gate cutting pattern extending in the second direction across the gate pattern to separate portions of the gate pattern,
wherein in a third direction perpendicular to the first and second directions, a level of a lower end of the separation pattern is higher than a level of a lower end of the gate cutting pattem.

2. The semiconductor device of claim 1, wherein the semiconductor device further comprises a dummy source/drain pattern, wherein the lower source/drain pattern is on the dummy source/drain pattern,
wherein the level of the lower end of the separation pattern is higher than a level of a lower end of the dummy source/drain pattern, and
wherein the level of the lower end of the gate cutting pattern is higher than or equal to the level of the lower end of the dummy source/drain pattern.

3. The semiconductor device of claim 2, wherein the semiconductor device further comprises a lower wiring structure, wherein the active pattern is on the lower wiring structure,
wherein the separation pattern is on the active pattern, and wherein a lower portion of the separation pattern is spaced apart from the lower wiring structure,
wherein the lower end of the gate cutting pattern is in contact with the lower wiring structure, and
wherein the lower end of the dummy source/drain pattern is in contact with the lower wiring structure.

4. The semiconductor device of claim 1, 2 or 3,
wherein the gate cutting pattern is arranged between the gate pattern and the separation pattern in the first direction, and
wherein the separation pattern extends in the first direction the gate cutting pattern to another gate cutting pattern spaced apart from the gate cutting pattern in the first direction.

5. The semiconductor device of any one of claims 1 to 4, wherein the semiconductor device further comprises a separation structure with a longest extent in the first direction, wherein the separation structure extends on a plurality of portions of the active pattern spaced apart from one another in the first direction, and
wherein the separation structure is arranged adjacent to a lateral side of the lower source/drain pattern and the upper source/drain pattern in the second direction.

6. The semiconductor device of any one of claims 1 to 5, wherein the separation pattern comprises:
a body portion adjacent to the gate cutting pattern in the first direction, and
a protrusion portion protruding from the body portion into the gate cutting pattern in the first direction.

7. The semiconductor device of any one of claims 1 to 6, wherein the semiconductor device further comprises a through-via extending in the gate cutting pattern.

8. The semiconductor device of claim 7, wherein the through-via comprises:
a first via portion extending from a lowest level of the through-via to an uppermost level of the through-via in the third direction, and
a second via portion and a third via portion that are arranged adjacent to a lateral side of the first via portion in the first direction and alternately arranged in the second direction,
wherein the third via portion is arranged between the first via portion and the separation pattern in the first direction,
wherein the second via portion extends from the lowest level of the through-via to the uppermost level of the through-via in the third direction, and
wherein the third via portion has a lower end intermediate between the lowest level and the uppermost level of the through-via in the third direction, and extends to the uppermost level of the through-via in the third direction.

9. **The** semiconductor device of claim 8, wherein:
a level of an upper end of the third via portion in the third direction is a same as levels of upper ends of the first via portion and the second via portion, and
a length of the third via portion in the third direction is shorter than lengths of the first via portion and the second via portion in the third direction.

10. **The** semiconductor device of claim 7, 8, or 9, wherein the gate cutting pattern comprises:
a gapfill insulating layer, and
an insulating liner on opposite lateral sides of the gapfill insulating layer in the first direction.

11. The semiconductor device of claim 10,
wherein the through-via is adjacent to the insulating liner in the first direction,
wherein the through-via is on the gapfill insulating layer, optionally
wherein:
the gapfill insulating layer comprises silicon oxide,
the insulating liner comprises silicon nitride, and
the separation pattern comprises silicon nitride, and and/ or wherein the gapfill insulating layer comprises an insertion portion, wherein the third via portion is on the insertion portion, and wherein the insertion portion is alternately arranged with the second via portion in the second direction.

12. The semiconductor device of any one of claims 7 to 11, wherein a portion of the separation pattern extends into the gate cutting pattern and is in contact with the through-via.

13. The semiconductor device of any one of claims 7 to 12, wherein the separation pattern comprises:
a body portion adjacent to the gate cutting pattern in the first direction, and
a protrusion portion protruding from the body portion into the gate cutting pattern in the first direction,
wherein the protrusion portion of the separation pattern protrudes into a first lateral side of the gate cutting pattern in the first direction and extends to a second lateral side, opposite the first lateral side, of the gate cutting pattern, and
wherein the through-via extends in the second direction between the protrusion portion at the first lateral side of the gate cutting pattern and the protrusion portion at the second lateral side of the gate cutting pattern.

14. The semiconductor device of any one of claims 7 to 13, wherein the semiconductor device further comprises:
an upper source/drain contact on the upper source/drain pattern and electrically connected to the upper source/drain pattern, and
a lower source/drain contact, wherein the lower source/drain pattern is on the lower source/drain contact and electrically connected to the lower source/drain contact,
wherein the upper source/drain contact and the lower source/drain contact are electrically connected to the through-via.

15. The semiconductor device of claim 14, wherein the semiconductor device further comprises:
a connecting portion, wherein the lower source/drain contact and the through-via are on the connection portion, the connecting portion extending in the first direction to electrically connect the lower source/drain contact with the through-via, and optionally wherein the gate cutting pattern comprises:
a gapfill insulating layer; and
an insulating liner on opposite lateral sides of the gapfill insulating layer in the first direction,
wherein the gapfill insulating layer comprises silicon oxide,
wherein the insulating liner comprises silicon nitride,
wherein the separation pattern comprises silicon oxide, and
wherein the semiconductor device further comprises a through-via extending in the gate cutting pattern, wherein the through-via comprises:
a first via portion extending from a lowest level of the through-via to an uppermost end of the through-via in the third direction, and
a second via portion and a third via portion that are arranged adjacent to a lateral side of the first via portion in the first direction and alternately arranged in the second direction,
wherein the third via portion is arranged between the first via portion and the separation pattern in the first direction, and
wherein a level of a lower end of the third via portion in the third direction is the same as a level of a lower end of the second via portion.
